(19) Europäisches Patentamt
European Patent Office
Office européen des brevets

(11) **EP 3 068 725 B1**

(12) **FASCICULE DE BREVET EUROPEEN**

(45) Date de publication et mention de la délivrance du brevet:
**16.08.2023   Bulletin 2023/33**

(21) Numéro de dépôt: **14802369.0**

(22) Date de dépôt: **14.11.2014**

(51) Classification Internationale des Brevets (IPC):
**C01B 32/162** *(2017.01)*    **C01B 32/164** *(2017.01)*
**B01J 19/22** *(2006.01)*

(52) Classification Coopérative des Brevets (CPC):
**B01J 19/22; B01J 4/002; B01J 19/1862; C01B 32/162; C01B 32/164;** B01J 2219/00159; B01J 2219/00186

(86) Numéro de dépôt international:
**PCT/EP2014/074600**

(87) Numéro de publication internationale:
**WO 2015/071408 (21.05.2015 Gazette 2015/20)**

(54) **PROCEDE DE FABRICATION AU DEFILE ET EN CONTINU DE NANOSTRUCTURES ALIGNEES SUR UN SUPPORT ET DISPOSITIF ASSOCIE**

VERFAHREN ZUR KONTINUIERLICHEN HERSTELLUNG VON AUF EINEM SUBSTRAT AUSGERICHTETEN NANOSTRUKTUREN UND ZUGEHÖRIGE VORRICHTUNG

METHOD FOR CONTINUOUS, TRAVELLING PRODUCTION OF NANOSTRUCTURES ALIGNED ON A SUBSTRATE AND RELATED DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.11.2013   FR 1361119**

(43) Date de publication de la demande:
**21.09.2016   Bulletin 2016/38**

(73) Titulaire: **Commissariat à l'Énergie Atomique et aux Énergies Alternatives 75015 Paris (FR)**

(72) Inventeurs:
• BOULANGER, Pascal
  F-13510 Eguilles (FR)
• MAYNE, Martine
  F-91470 Les Molieres (FR)
• PINAULT, Mathieu
  F-94260 Fresnes (FR)
• CHARON, Emeline
  F-75013 Paris (FR)
• REYNAUD, Cécile
  F-94230 Cachan (FR)

(74) Mandataire: **Brevalex Tour Trinity 1 B Place de la Défense 92400 Courbevoie (FR)**

(56) Documents cités:
EP-A1- 2 450 310        US-A1- 2009 053 115
US-A1- 2011 318 256

• CASTRO C ET AL: "Dynamics of catalyst particle formation and multi-walled carbon nanotube growth in aerosol-assisted catalytic chemical vapor deposition", CARBON, ELSEVIER, OXFORD, GB, vol. 48, no. 13, 1 novembre 2010 (2010-11-01), pages 3807-3816, XP027189805, ISSN: 0008-6223 [extrait le 2010-06-25]
• BARREIRO A ET AL: "On the effects of solution and reaction parameters for the aerosol-assisted CVD growth of long carbon nanotubes", APPLIED PHYSICS A; MATERIALS SCIENCE & PROCESSING, SPRINGER, BERLIN, DE, vol. 82, no. 4, 1 mars 2006 (2006-03-01), pages 719-725, XP019337187, ISSN: 1432-0630, DOI: 10.1007/S00339-005-3436-5

**Description**

**DOMAINE TECHNIQUE**

La présente invention se rapporte à la fabrication en continu de nanostructures alignées sur un matériau hôte qui défile, les nanostructures étant du type nanofils ou nanotubes et le matériau hôte pouvant être un substrat, une fibre ou tout autre support.

Plus particulièrement, l'invention se rapporte à un procédé dédié à la fabrication en continu de nanostructures alignées sur un support par dépôt chimique catalytique en phase vapeur et à son dispositif associé.

Le procédé et le dispositif selon l'invention ont de nombreuses applications possibles. Ils peuvent par exemple servir pour la réalisation de nanotubes alignés. De manière avantageuse, le procédé permet de réaliser des nanotubes alignés à base de carbone avec ou sans insertion d'hétéroatomes (les hétéroatomes étant par exemple du phosphore, du bore ou de l'azote). D'autres structures tubulaires peuvent également être envisagées comme, par exemple et de manière non exhaustive, des nanotubes de nitrure de bore, de dioxyde de titane, de silicène ou autre. De la même façon, le procédé et le dispositif selon l'invention peuvent servir pour la réalisation de nanofils alignés, par exemple des nanofils alignés en silicium ou composés de différents composants comme, par exemple et de manière non exhaustive, des oxydes (oxyde de zinc) ou des carbures (carbure de silicium ou de zinc).

De telles nanostructures organisées peuvent avantageusement être utilisées, par exemple, pour la fabrication de membranes nanoporeuses (membranes de filtration). Elles peuvent également servir à la fabrication d'électrodes, de matériaux composites ou encore pour la réalisation de composants électroniques et de dispositifs convertisseurs d'énergie.

**ÉTAT DE LA TECHNIQUE ANTÉRIEURE**

Les nanostructures (c'est-à-dire les structures qui possèdent au moins une dimension caractéristique (largeur, diamètre ou autre) inférieure à 100 nm) peuvent être élaborées sous la forme de réseaux de nanostructures alignées sur un support.

Cet agencement particulier est avantageux, car il permet de fabriquer des nanostructures dans des conditions de sécurité améliorées par rapport à un procédé qui fabriquerait des nanostructures dispersées et collectées sous forme de poudre. En effet, lors de la croissance de réseaux de nanostructures alignées sur un support (substrat par exemple), les nanostructures sont solidaires du support et, du fait de leur organisation et de leur assemblage entre elles, elles sont très peu dispersables dans l'environnement.

De plus, cet agencement particulier, couplé au fait que les nanostructures ont toutes la même hauteur, les rend intéressantes par rapport à des nanostructures collectées sous forme de poudre et présentant une organisation aléatoire et une longueur variable, et facilite la mise en forme de ces nanostructures pour certaines applications, dans les matériaux composites par exemple. Cet agencement particulier permet en outre, dans le cas particulier des nanotubes et des nanofils, d'exploiter leurs propriétés unidirectionnelles et de les mettre en oeuvre dans de nombreuses applications (par exemple, la fabrication de membranes de filtration et d'électrodes, comme cité ci-dessus).

Aujourd'hui, il existe de nombreux procédés qui permettent de synthétiser des réseaux de nanostructures verticalement alignées sur un support en utilisant les techniques du dépôt chimique en phase vapeur (CVD pour « Chemical Vapor Déposition » en anglais). Tous ces procédés peuvent toutefois être classés en deux groupes.

Il y a, d'une part, les procédés de synthèse qui reposent sur un pré-dépôt du catalyseur sur le support, suivi de la croissance par CVD des nanostructures sur le catalyseur par l'apport d'un précurseur sous forme gazeuse (source du matériau des nanostructures) dans l'enceinte CVD. Le pré-dépôt du catalyseur sur le support peut être obtenu par une méthode de type dépôt par voie physique (par pulvérisation cathodique (« sputtering » en anglais) ou par épitaxie par jets moléculaires (« MBE » en anglais) par exemple) ou par une méthode de type dépôt par voie chimique (enduction, dépôt par trempage (« dip-coating » en anglais), dépôt à la tournette (« spin-coating » en anglais), pulvérisation (« spray » en anglais), électrodépôt, etc.). A titre d'exemple, un procédé de synthèse de ce type sur substrat défilant est illustré dans les demandes de brevet US 2010/0260933 A1 et US 2013/0045157 A1 (références **[1]**, **[2]**).

Il y a, d'autre part, les procédés de synthèse qui sont réalisés en procédant à une injection simultanée et continue (ou co-injection) d'un précurseur du matériau des nanostructures (source carbonée pour des nanostructures en carbone) et d'un précurseur catalytique sur le support. A titre d'exemple, un procédé de synthèse de ce type sur substrat défilant est illustré dans la demande de brevet US 2009/0053115 A1 (référence [3]).

Il s'avère que, pour la réalisation en continu de nanostructures alignées sur un support, la synthèse par co-injection d'un précurseur source et du précurseur catalytique est plus appropriée que la méthode nécessitant un pré-dépôt du catalyseur. En effet, l'alimentation en continu d'un précurseur source et du précurseur catalytique permet une synthèse sans fin, tant que le précurseur source et le précurseur catalytique sont injectés dans l'enceinte CVD.

Comparativement, la méthode CVD par pré-dépôt est limitée par la durée de vie du catalyseur qui, dans le cas des nanotubes de carbone, se trouve empoisonné par le carbone du précurseur carboné si aucun adjuvant n'est ajouté à la source carbonée. Récemment, des adjuvants tel que l'oxygène sous forme de vapeur d'eau ont permis d'augmenter la durée de vie des catalyseurs et il est actuellement possible de synthétiser ainsi des nanotubes de carbone mono-feuillets alignés et d'épaisseur contrôlable. Toutefois, même si la croissance continue de nanostructures alignées est possible à partir de la méthode CVD par pré-dépôt, la synthèse par co-injection continue d'un précurseur source et du précurseur catalytique présente l'avantage de pouvoir être réalisée en une seule étape de réaction dans une seule enceinte CVD (c'est-à-dire un seul four CVD), du fait de l'alimentation simultanée d'un précurseur source et du précurseur catalytique. Au final, la synthèse par co-injection est préférable pour des raisons de coût et de sécurité.

Il est à noter que certaines méthodes de synthèse reposant sur un pré-dépôt peuvent enchainer les deux étapes de pré-dépôt et de croissance. Cependant, la complexité de l'enchaînement des étapes est très grande, avec par exemple des phases de traitement du pré-dépôt, qui vont fortement ralentir la vitesse de défilement du support et donc diminuer la productivité et augmenter le coût des nanostructures ainsi réalisées sur ce support.

Par ailleurs, il est connu que, dans le cas d'une synthèse de nanotubes de carbone par la méthode de co-injection du catalyseur, il est possible d'influer sur les caractéristiques morphologiques et structurales des nanotubes en modifiant les conditions de synthèse. On sait ainsi que le diamètre des nanotubes est influencé par la présence d'hydrogène (référence [4]), leur densité est influencée par le pourcentage massique en précurseur catalytique et leur longueur est, quant à elle, influencée par la durée de la synthèse (référence [5]).

La référence [7] montre les rôles joués par la température, la concentration massique en ferrocène ou le débit du gaz porteur dans la synthèse de nanotubes de carbone par la méthode de co-injection du catalyseur.

À partir de là, les inventeurs ont cherché à savoir ce qui arriverait si, au lieu de modifier les conditions de synthèse des nanotubes entre deux synthèses distinctes, on modifiait les conditions de synthèse au cours d'une même synthèse en continu, notamment en faisant défiler le support des nanostructures et/ou en réduisant considérablement la teneur en précurseur catalytique au cours de la synthèse

C'est ainsi qu'au cours de leurs expérimentations, les inventeurs ont constaté qu'en réalisant des synthèses avec des concentrations très faibles, et de préférence constantes, en précurseur catalytique (typiquement comprises entre 0,05 et 0,5 % en poids), le rendement catalytique de la synthèse et la vitesse de croissance des nanostructures en carbone augmentent considérablement et, par conséquent, que la teneur en fer diminue considérablement. À titre d'exemple, on obtient un facteur d'augmentation de 20 à 25 % pour le rendement catalytique, un facteur d'augmentation de 2,5 % pour la vitesse de croissance et un facteur de diminution de 20 à 25 % pour la teneur en fer pour une synthèse de nanostructures de carbone à 0,1 % en poids en ferrocène, comparée à une synthèse à 2,5 % en poids en ferrocène.

Les inventeurs ont également constaté qu'en débutant une synthèse à partir d'une solution de précurseurs contenant une forte concentration en précurseur catalytique (typiquement 2,5 % en poids) pendant une durée allant jusqu'à quelques minutes (typiquement de 0,5 à 2 minutes), puis en réduisant fortement cette concentration en précurseur catalytique (typiquement jusqu'à des valeurs de 0,01 % en poids) pendant une durée au moins deux fois plus longue, on augmente le rendement global et la vitesse de croissance des nanostructures de carbone. A titre d'exemple, on obtient une augmentation de 3 à 37 % pour le rendement global et de 11 à 26 % pour la vitesse de croissance en fonction de la durée d'injection de la solution à forte concentration en précurseur catalytique (30 s ou 1 min40, la solution à faible concentration étant injectée pendant des durées respectives de 14min30 ou 13min20)), comparée à une simple injection à faible concentration de précurseur catalytique (typiquement 0,1 % en poids) pendant 15 minutes lors de la synthèse de nanostructures de carbone.

Ainsi, les inventeurs ont constaté que la modification des conditions opératoires au cours d'une synthèse par co-injection, et en particulier l'abaissement de la concentration en précurseur catalytique jusqu'à des valeurs très faibles (typiquement de 1% à 0,01 % en poids), permet d'agir considérablement sur la pureté des nanostructures carbonées, ainsi que sur le rendement global et la vitesse de croissance.

En parallèle, les inventeurs ont cherché à élaborer un procédé de synthèse, et à concevoir un dispositif associé, permettant une fabrication à l'échelle industrielle de nanostructures alignées, en prenant en compte un objectif de coût moindre et de productivité accrue. Ils ont pour cela astucieusement décidé de concevoir un dispositif et un procédé permettant de transposer des conditions de synthèse temporelle (c'est-à-dire des conditions de synthèse différentes au cours du temps) en conditions de synthèse spatiale (c'est-à-dire des conditions de synthèse différentes en fonction de la localisation du support dans le dispositif) de nanostructures sur un support. En transposant des conditions opératoires de synthèse variant au cours du temps en conditions opératoires de synthèse variant spatialement, il est alors possible d'obtenir une production continue de nanostructures alignées sur un substrat défilant.

L'ensemble des constatations scientifiques et techniques ci-dessus, ainsi que la conception d'un dispositif permettant de réaliser des conditions de synthèse variables spatialement, font l'objet de la présente invention.

## EXPOSÉ DE L'INVENTION

L'invention concerne donc, en premier lieu, un procédé de fabrication en continu de nanostructures alignées sur un support défilant, comprenant le convoyage du support à travers un espace chauffé et la synthèse, dans cet espace, des nanostructures alignées sur le support par dépôt chimique catalytique en phase vapeur. Le procédé est caractérisé en ce que, l'espace chauffé étant divisé en n zones consécutives dans le sens de convoyage du support, n étant un nombre entier supérieur ou égal à 2, la synthèse des nanostructures résulte d'opérations de chauffage et d'opérations d'injection, dans chacune des n zones, d'un flux d'un aérosol contenant un précurseur catalytique et un précurseur source du matériau des nanostructures à former, véhiculé par un gaz porteur et en ce que les opérations d'injection sont réalisées en modifiant, dans au moins deux des n zones, au moins un paramètre choisi parmi le débit du flux du gaz porteur, la composition chimique du gaz porteur, la concentration massique du précurseur catalytique dans le mélange du précurseur catalytique et du précurseur source. En procédant ainsi, on obtient des conditions de synthèse des nanostructures différentes dans au moins deux des n zones.

Le gaz porteur peut être un gaz inerte ou un gaz réactif; l'aérosol, quant à lui, correspond à la dispersion, sous forme de gouttelettes, du liquide ou de la solution contenant le précurseur catalytique et/ou le précurseur source dans le gaz porteur, cette dispersion étant obtenue par pulvérisation ou par nébulisation du liquide ou de la solution dans le gaz porteur.

Il est à noter que, dans ce qui suit, la concentration massique du précurseur catalytique est toujours, et même lorsque cela n'est pas précisé, sa concentration massique dans le mélange de précurseurs (précurseur source + précurseur catalytique). Par « précurseur source », on entend un composé solide, liquide, ou gazeux, précurseur du matériau des nanostructures à former.

Dans le cadre de la présente invention, on entend par « fabrication en continu et sur un support défilant » une fabrication pour laquelle les deux éléments suivants sont réalisés :

- une injection pour laquelle l'ensemble des précurseurs (catalytique et source) sont injectés simultanément (co-injection) ou bien pour laquelle chacun des précurseurs est injecté séparément, cette injection étant réalisée dans tous les cas sans interruption (continument dans le temps) lors de la croissance des nanostructures sur le support (substrat ou autre), par opposition à une synthèse du type pré-dépôt qui se décompose en une étape de pré-dépôt d'un catalyseur sur le support, puis en une étape de croissance des nanostructures sur le catalyseur à partir d'un précurseur source ;
- un convoyage du substrat de telle sorte que le substrat demeure de manière continue dans la zone réactionnelle de synthèse selon une vitesse constante et non nulle, lorsque le substrat est en un seul tenant ; dans le cas particulier d'un convoyage d'un substrat en plusieurs tenants successifs (plaques à plaques, par exemple), cela peut correspondre à une vitesse de défilement momentanément égale à zéro, le substrat étant alors convoyé dans la zone réactionnelle et stoppé lorsqu'il est à l'endroit voulu pour débuter l'injection.

Il est à noter que le temps de résidence du support dans une zone n est fonction de la vitesse de défilement du support et est défini comme étant la taille L (longueur dans le sens du défilement) d'une zone n de synthèse divisée par la vitesse de défilement V du substrat. On peut ainsi traduire une synthèse séquencée de X étapes de durée $T_1$ à $T_X$ sur substrat fixe, comme équivalente à une synthèse sur X zones adjacentes de taille $L_1$ à $L_X$ tel que $L_i = V \times T_i$ (quel que soit i de 1 à X).

Avantageusement, les nanostructures alignées sous forme de tapis sont en carbone, le précurseur catalytique est un métallocène de métaux de transition (de préférence un métallocène du fer, du cobalt ou du nickel) et le précurseur source est un hydrocarbure (de préférence le toluène, le benzène, le xylène, le cyclohexane ou l'hexane). De préférence, le précurseur catalytique est le ferrocène et le précurseur source est le toluène.

Avantageusement, le précurseur catalytique injecté dans les n zones a une concentration massique dans le mélange du précurseur catalytique et du précurseur source qui est constante.

Selon une première variante possible du procédé objet de l'invention, le précurseur catalytique injecté a, dans au moins l'une des n zones, une concentration massique dans le mélange du précurseur catalytique et du précurseur source qui est supérieure ou égale à 0,01 % en poids et inférieure ou égale à 1 % en poids. De préférence, le précurseur catalytique injecté dans ladite au moins une des n zones a une concentration massique dans le mélange du précurseur catalytique et du précurseur source qui est supérieure ou égale à 0,05 % en poids et inférieure ou égale à 0,5 % en poids.

Selon un mode de réalisation préféré de cette première variante dans lequel le précurseur catalytique est le ferrocène et le précurseur source est le toluène, la concentration en ferrocène présent dans le mélange du précurseur catalytique et du précurseur source (mélange du ferrocène et du toluène) est comprise entre 0,05 % et 0,5 % en poids. Dans cette gamme de valeurs, les inventeurs ont constaté que le rendement catalytique de la synthèse et la vitesse de croissance des nanostructures augmentent considérablement, diminuant ainsi considérablement la teneur en fer (et augmentant la pureté des nanostructures). Préférentiellement, la concentration en ferrocène est comprise entre 0,1 % et 0,25 % en poids, gamme dans laquelle le rendement catalytique et la vitesse de croissance obtenus sont les plus élevés, ce qui présente un avantage significatif en termes de production et de pureté des nanostructures carbonées.

Le rendement global est défini comme étant égal au rapport entre la masse totale de produit obtenu (typiquement carbone et fer pour des nanostructures carbonées) sur la masse totale de précurseurs injectés (précurseur catalytique et précurseur source des nanostructures).

La vitesse de croissance, quant à elle, est définie comme étant égale au rapport entre la longueur totale des nanostructures (ce qui, dans notre cas, correspond également à l'épaisseur du tapis de nanostructures) sur la durée totale de croissance.

Enfin, la pureté est définie comme étant égale au rapport de la masse de l'élément caractéristique du produit obtenu (typiquement le carbone pour des nanostructures carbonées) sur la masse totale du produit obtenu. Autrement dit, la pureté du produit obtenu peut aussi s'évaluer à partir de la concentration massique en catalyseur résiduel dans le produit final, qui doit être inférieure à 5 % en poids, préférentiellement inférieure à 3 % en poids, idéalement inférieure à 1 % en poids.

Selon une seconde variante possible du procédé objet de l'invention, soit le centre des n zones du dispositif, la concentration totale massique en précurseur catalytique présent dans le mélange du précurseur catalytique et du précurseur source injecté sous forme d'aérosol dans la ou l'ensemble des zones situées en amont du centre selon le sens de convoyage est au moins deux fois supérieure à la concentration totale massique en précurseur catalytique présent dans le mélange du précurseur catalytique et du précurseur source injecté sous forme d'aérosol dans la ou l'ensemble des zones situées en aval du centre selon le sens de convoyage.

Selon une troisième variante possible du procédé objet de l'invention, la concentration massique en précurseur catalytique dans le mélange du précurseur catalytique et du précurseur source injecté sous forme d'aérosol dans l'une des n zones (dite zone de haute concentration) est au moins deux fois supérieure à la concentration massique en précurseur catalytique dans le mélange du précurseur catalytique et du précurseur source injecté sous forme d'aérosol dans chacune des n-1 zones restantes.

De préférence, la zone de haute concentration est la première zone selon le sens de convoyage.

On entend par concentration totale en précurseur catalytique dans la ou l'ensemble des zones situées en amont (en aval) du centre la somme des concentrations en précurseur catalytique dans la ou les zones situées en amont (ou en aval) du centre.

Selon un mode de réalisation préféré de cette troisième variante, la concentration massique en précurseur catalytique présent dans le mélange du précurseur catalytique et du précurseur source injecté sous forme d'aérosol dans la zone de haute concentration est comprise entre 2 % en poids et la limite de saturation du précurseur catalytique dans le précurseur source (cette valeur varie en fonction du précurseur catalytique et du précurseur source ; par exemple, elle est de l'ordre de 15 % en poids de ferrocène dans du toluène) et la concentration massique en précurseur catalytique présent dans le mélange du précurseur catalytique et du précurseur source injecté sous forme d'aérosol dans les n-1 zones restantes est inférieure ou égale à 1 % en poids. De préférence, la concentration massique en précurseur catalytique qui est injecté dans la zone de haute concentration est comprise entre 2,5 et 10 % en poids, préférentiellement jusqu'à 5 % en poids, et la concentration massique en précurseur catalytique qui est injecté dans les n-1 autres zones est inférieure ou égale à 0,1 % en poids.

Selon un mode de réalisation préféré de cette troisième variante dans lequel le précurseur catalytique est le ferrocène et le précurseur source est le toluène, la concentration en ferrocène présent dans le mélange du précurseur catalytique et du précurseur source (mélange ferrocène/toluène) qui est injecté sous forme d'aérosol dans la zone à haute concentration en précurseur catalytique est comprise entre 0,5 et 10 % en poids, de préférence entre 1 et 5 % en poids, et la concentration en ferrocène présent dans le mélange du précurseur catalytique et du précurseur source injecté sous forme d'aérosol dans les autres zones est inférieure ou égale à 0,5 % en poids, de préférence inférieure ou égale à 0,25 % en poids et plus préférentiellement inférieure ou égale à 0,1 % en poids.

Cette troisième variante résulte de la constatation des inventeurs selon laquelle, en débutant une synthèse à partir d'une solution de précurseurs contenant une forte concentration en précurseur catalytique (typiquement 2,5 % en poids) pendant quelques minutes (typiquement de 0,5 à 2 minutes), puis en réduisant fortement cette concentration en précurseur (typiquement jusqu'à des valeurs de 0,01 % en poids), on augmentait le rendement global et la vitesse de croissance. A titre d'exemple, on obtient une augmentation de 3 à 37 % pour le rendement global et de 11 à 26 % pour la vitesse de croissance en fonction de la durée d'injection de la solution à forte concentration en précurseur catalytique (30 s ou 1 min40, la solution à faible concentration étant injectée pendant des durées respectives de 14min30 ou 13min20), comparée à une simple injection à faible concentration de précurseur catalytique (typiquement 0,1 % en poids pendant 15 minutes).

On peut également noter que le dépôt chimique catalytique en phase vapeur (ou CCVD en anglais) qui est utilisé pour réaliser les nanostructures est un procédé de dépôt connu et n'est donc pas décrit ici en détails. Il permet de réaliser des dépôts localisés (d'une épaisseur maîtrisée essentiellement en fonction de la durée d'injection des précurseurs) à partir, par exemple, de précurseurs chimiques liquides ou de précurseurs solides et solubles dans un liquide qui joue ou non le rôle de précurseur source des nanostructures à former, les précurseurs étant injectés sous forme d'aérosols qui sont vaporisés, puis transformés par décomposition thermique et/ou catalytique pour donner naissance aux nanostructures.

Selon une autre variante possible du procédé objet de l'invention, les opérations d'injection étant réalisées en modifiant, dans au moins deux des n zones, au moins un paramètre choisi parmi le débit du flux du gaz porteur, la composition chimique du gaz porteur, la concentration massique du précurseur catalytique dans le mélange du précurseur catalytique et du précurseur source, les opérations d'injection sont en outre réalisées en modifiant, dans au moins deux des n zones, le débit d'injection du mélange du précurseur catalytique et du précurseur source. Il est à noter que lesdites au moins deux zones dans lesquelles le débit d'injection du mélange est modifié peuvent ou non être différentes des au moins deux zones dans lesquelles au moins un paramètre choisi parmi le débit du flux du gaz porteur, la composition chimique du gaz porteur et la concentration massique du précurseur catalytique dans le mélange du précurseur catalytique et du précurseur source est modifié.

Avantageusement, dans le procédé objet de l'invention, les opérations de chauffage sont réalisées à une température différente dans au moins deux des n zones.

Avantageusement, la synthèse des nanostructures résulte en outre d'opérations d'injection d'un flux d'au moins un fluide réactif dans au moins une des n zones. Dans le cadre de la présente invention, on entend par « fluide réactif » tout gaz ou liquide intervenant dans la synthèse des nanostructures. Le fluide réactif peut par exemple être choisi parmi l'eau ($H_2O$), l'ammoniac ($NH_3$), l'azote ($N_2$), le dihydrogène ($H_2$), l'acétylène ($C_2H_2$), le méthane ($C_2H_4$), l'éthylène ($CH_3$), le dioxyde de carbone ($CO_2$).

L'invention concerne également un dispositif spécialement conçu pour la mise en oeuvre du procédé tel que décrit ci-dessus. Ce dispositif comprend :

- une enceinte, munie d'une entrée et d'une sortie par lesquelles le support entre et sort respectivement ;
- une chambre de réaction (correspondant à l'espace chauffé mentionné dans le procédé), située dans l'enceinte entre l'entrée et la sortie, et divisée en n zones, selon le sens de convoyage, n étant un nombre entier supérieur ou égal à 2 ;
- des moyens pour convoyer, selon un sens de convoyage, le support de l'entrée à la sortie de l'enceinte en passant par la chambre de réaction.

Ce dispositif est caractérisé en ce que chaque zone est équipée :

- d'un premier système d'injection pour injecter, dans la zone associée, un flux d'un aérosol contenant un précurseur catalytique et un précurseur source du matériau des nanostructures à former, véhiculé par un gaz porteur ;
- d'un premier élément de chauffage individuel, configuré pour chauffer le substrat lors de son passage dans la zone associée ;
- d'un deuxième élément de chauffage individuel, configuré pour chauffer l'aérosol injecté dans la zone associée.

Le dispositif selon l'invention présente l'avantage de permettre une production industrielle de structures nanométriques alignées, à un coût attractif et selon une productivité accrue, puisque la production des nanostructures est obtenue sur un substrat défilant. Grâce à ce dispositif, il est possible de transposer des conditions opératoires de synthèse variables au cours du temps en conditions de synthèse variables spatialement, pour une production continue de nanostructures alignées sur un substrat défilant.

Avantageusement, au moins deux des n premiers systèmes d'injection sont configurés pour injecter l'aérosol avec un paramètre, choisi parmi le débit du gaz porteur et la concentration massique en précurseur catalytique dans le mélange du précurseur catalytique et du précurseur source, qui est différent.

Selon une variante, au moins une des n zones est en outre équipée d'un deuxième système d'injection pour injecter, dans la zone associée, un flux d'au moins un fluide réactif. De préférence, chacune des n zones est équipée d'un deuxième système d'injection. Avantageusement, au moins deux des n zones sont équipées du deuxième système d'injection et au moins deux de ces deuxièmes systèmes d'injection sont configurés pour injecter le ou les fluides réactifs, dans les zones associées, avec un paramètre, choisi parmi le débit du ou des fluides réactifs, la composition chimique et la concentration des différents constituants du ou des fluides réactifs, qui est différent.

Selon une autre variante, le flux de l'aérosol contenant un précurseur catalytique et un précurseur source du matériau des nanostructures à former est injecté simultanément avec le gaz porteur et/ou le flux du fluide réactif.

De préférence, le flux de l'aérosol et, s'il est présent, le flux de fluide(s) réactif(s), sont injectés selon une direction essentiellement perpendiculaire (c'est-à-dire à 90° +/- 30°), de préférence perpendiculaire, aux moyens de convoyage, et donc au support, ce qui permet de concentrer le dépôt de la majorité des réactifs à la surface du support.

Le chauffage des premier et deuxième éléments de chauffage peut être obtenu par convection, induction, conduction ou radiation. Ainsi, dans chacune des n zones, les conditions locales de croissance des nanostructures sont déterminées par les paramètres relatifs aux aérosols et aux éventuels fluides réactifs qui y sont injectés (type d'aérosols et de fluides réactifs injectés, flux et concentration d'un constituant dans le milieu de dissolution ou de dilution), les conditions d'injection (l'injection pouvant être continue ou pulsée), ainsi que par les conditions de température, chaque zone ayant ses propres moyens de chauffage et la température pouvant donc être adaptée. Il est à noter qu'il est possible d'assister la croissance des nanostructures par des moyens additionnels, comme par exemple l'emploi d'un champ électrique ou d'un plasma, qui peuvent être appliqués indépendamment sur chaque zone.

Avantageusement, le dispositif comprend en outre des moyens de commande d'injection, associés à chaque premier système d'injection, qui sont conçus pour déclencher une injection d'un flux d'aérosol dans la zone associée lorsque le support pénètre dans cette zone et maintenir cette injection jusqu'à ce que le support sorte de cette zone. Cela permet de réduire la consommation en matières premières et ainsi diminuer les coûts de fabrication des nanostructures alignées sur un support.

Avantageusement, au moins deux zones adjacentes sont séparées l'une de l'autre par une cloison ayant une ouverture permettant le passage du support, des moyens de confinement étant placés au niveau de cette ouverture pour empêcher le passage de fluides et d'aérosols d'une zone à l'autre. La présence d'une cloison (et de moyens de confinement) entre deux zones est particulièrement utile lorsque les aérosols et fluides injectés sont très différents (en composition ou en concentration) d'une zone à l'autre.

De préférence, les zones ont, selon un plan en coupe perpendiculaire au sens de convoyage des moyens de convoyage, une forme polygonale, par exemple trapézoïdale, dont la petite base représente la partie haute de la zone (là où sont situés, de préférence, les injecteurs des premier et deuxième systèmes d'injection, ainsi que les deuxièmes éléments de chauffage), tandis que la grande base représente la partie basse de la zone où sont situés les premiers éléments de chauffage. Cette forme particulière est adaptée à la forme de cône que présentent souvent les flux injectés : cette forme permet d'obtenir une bonne homogénéité des matériaux déposés, notamment en ajustant la hauteur du trapèze.

Selon une variante, l'enceinte peut en outre comporter une chambre de pré-traitement, qui est située en amont de (c'est-à-dire avant) la chambre de réaction, selon le sens de convoyage du support, et qui est munie d'une entrée et d'une sortie par lesquelles le support entre et sort respectivement, la chambre de pré-traitement étant équipée d'un système d'injection d'un fluide et de moyens de chauffage.

Dans cette chambre de pré-traitement, on forme, à partir du fluide injecté, une couche mince sur le support avant la formation des nanostructures, par exemple par dépôt chimique en phase vapeur (CVD), par dépôt par couche atomique (ALD), par dépôt d'une couche moléculaire (MLD), par dépôt chimique en phase vapeur assisté par plasma (PECVD), par dépôt chimique en phase vapeur à basse pression (LPCVD), par dépôt chimique en phase vapeur assisté d'un champ électrique (ELFICVD), par dépôt chimique en phase vapeur à élément catalyseur assisté par aérosol (AACCVD), etc. On peut par exemple déposer une couche en céramique ou une couche carbonée (par exemple du graphène) sur un support en carbone ou en acier.

La présence d'une chambre de pré-traitement permet de préparer spécifiquement le support avant la synthèse des nanostructures. Attention, cette éventuelle préparation du support ne doit pas être confondue avec une étape de pré-dépôt de catalyseur. Lors de ce pré-traitement, on peut par exemple déposer une couche destinée à servir de couche barrière à la diffusion du précurseur source et du précurseur catalytique entre le support et les nanostructures, comme exposé dans la référence [6], ou destinée à améliorer la compatibilité chimique des nanostructure avec le support. On peut ainsi obtenir des nanostructures alignées sur tout type de support compatible avec les conditions de croissance des nanostructures, même sur des supports sur lesquels la croissance des nanostructures est difficile.

Selon une autre variante, l'enceinte peut en outre comporter une chambre de post-traitement, qui est située en aval de (c'est-à-dire après) la chambre de réaction, selon le sens de convoyage du support, et qui est munie d'une entrée et d'une sortie par lesquelles le support entre et sort respectivement, la chambre de post-traitement étant équipée d'un système d'injection d'un fluide et de moyens de chauffage. Dans cette chambre de post-traitement, on forme, à partir du fluide injecté, une couche sur les nanostructures, par exemple par CVD, ALD, MLD, PECVD, LPCVD, ELFICVD, AACCVD, etc. On peut par exemple réaliser un dépôt d'une couche de silice à partir de TEOS (tétraéthoxysilane) sur des nanostructures de carbone alignées sur un support, ce qui permet de réaliser une encapsulation protectrice des nanotubes de carbone, par exemple en vue d'une fonctionnalisation future des nanotubes, ou bien encore pour des considérations de sûreté du produit obtenu, ce revêtement permettant de maintenir les nanotubes mieux accrochés à leur substrat. Selon l'épaisseur de la couche déposée, ce post-traitement permet d'obtenir le remplissage partiel ou total de l'espace entre les nanostructures.

Il est tout à fait possible d'avoir à la fois une chambre de pré-traitement et une chambre de post-traitement. On peut alors réaliser le pré-traitement, la croissance des nanostructures et le post-traitement dans la même enceinte CVD.

De préférence, des moyens de confinement sont situés à l'entrée et à la sortie de l'enceinte. Si l'enceinte comporte une chambre de pré-traitement et/ou une chambre de post-traitement, il est également préférable de disposer des moyens de confinement au niveau de la sortie de la chambre de pré-traitement et au niveau de l'entrée de la chambre de post-traitement, afin d'empêcher le passage d'un fluide provenant de l'une de ces deux chambres dans l'une ou l'autre des n zones de la chambre de réaction.

Au final, le procédé et le dispositif selon l'invention présentent de nombreux avantages. En particulier, ils ont l'avantage de pouvoir être mis en oeuvre pour une synthèse industrielle (production massive), sûre et applicable à des supports de grandes surfaces. En particulier, on obtient, avec le dispositif selon l'invention, un tapis de nanostructures alignées sur un support, le support pouvant être de grande dimension et occuper une grande partie de la surface disponible des moyens de convoyage (grille ou tapis roulant, par exemple) ou être de plus petites dimensions, rendant alors possible de disposer plusieurs supports les uns à côté des autres sur les moyens de convoyage. Le procédé et le dispositif selon l'invention permettent également d'éviter tout contact direct de l'opérateur avec les nanostructures au cours de leur synthèse. On peut également éviter tout contact direct de l'opérateur avec les nanostructures au cours de leur mise en forme, si l'on procède au dépôt d'une couche de protection sur les nanostructures dans une chambre de post-traitement. Ainsi, aucune manipulation humaine directe des nanostructures n'est nécessaire. Enfin, un même dispositif peut être utilisé pour fabriquer différentes nanostructures alignées sur un support : il suffit pour cela de modifier les aérosols et fluides réactifs introduits dans les n zones de la chambre de réaction en fonction des fabrications visées. En outre, chaque zone ayant ses propres systèmes d'injection et ayant ses propres éléments de chauffage, il est possible d'adapter les injections et les températures dans chacune des n zones de la chambre réaction. Il est donc aisé, avec le dispositif selon l'invention, de réaliser différents types de nanostructures alignées sur un support.

En outre, comme nous l'avons vu ci-dessus, la modification des conditions opératoires au cours de la synthèse, et notamment l'abaissement de la concentration en précurseur catalytique jusqu'à des valeurs très faibles (typiquement 0,01 % en poids), permet d'agir considérablement sur la pureté des nanostructures carbonées, sur le rendement global et/ou sur la vitesse de croissance. Au final, le choix entre les première, deuxième et troisième variantes du procédé selon l'invention s'opère de la manière suivante :

- si l'on souhaite obtenir des produits les plus purs possibles (c'est-à-dire avec plus de 95 % en poids de carbone, voire plus de 99%) tout en respectant des vitesses de croissance compatibles avec un procédé industriel ($\geq$ 20 $\mu$m/min), on privilégiera une synthèse en injectant de manière constante de très faibles quantités de précurseur catalytique (première variante) ;
- alors que si l'on souhaite augmenter la vitesse de croissance et le rendement global, on privilégiera une synthèse où les quantités de précurseurs varient pendant la synthèse (deuxième et troisième variantes).

L'invention sera mieux comprise à la lumière du complément de description qui suit, qui se rapporte à :

- des exemples de réalisation de tapis de nanotubes de carbone obtenus en faisant varier des conditions de synthèse dans le temps sur un substrat fixe, ces exemples permettant de mettre en évidence les bons résultats obtenus en procédant à des synthèses avec des concentrations très faibles en précurseur catalytique ;
- des exemples de modes opératoires pour la réalisation de tapis de nanotubes de carbone obtenus en faisant varier des conditions de synthèse dans l'espace sur un substrat défilant dans cet espace ;
- des exemples de possibilité de réalisation de profils d'injection des espèces dans les n zones en utilisant le dispositif et le procédé selon l'invention.

Bien entendu, ces exemples ne sont donnés qu'à titre d'illustrations de l'objet de l'invention et ne constituent en aucun cas une limitation de cet objet.

## BRÈVE DESCRIPTION DES DESSINS

La figure 1 représente une vue schématique en coupe du dispositif selon un mode de réalisation de la présente invention.
La figure 2 représente une vue schématique en coupe du dispositif selon un autre mode de réalisation de la présente invention.
La figure 3 représente une vue schématique en coupe prise le long de la ligne I-I de la figure 1.
Les figures 4a, 4b et 4c sont des graphes montrant respectivement les variations de la teneur en fer (figure 4a), du rendement catalytique (figure 4b) et de la vitesse de croissance des nanotubes (figure 4c) en fonction de la teneur en ferrocène injecté, les nanotubes étant obtenus selon un protocole de synthèse en co-injection en mode temporel, basé sur l'injection d'une concentration constante en ferrocène au cours d'une seule et même séquence.
Les figures 5a et 5b représentent des clichés des nanotubes de carbone alignés d'un tapis obtenu selon un protocole de synthèse en co-injection en mode temporel basé sur l'injection d'une concentration constante en ferrocène au cours d'une seule et même séquence et observés en microscopie électronique à balayage (MEB) selon deux agrandissements différents.
La figure 6 représente un spectre obtenu par spectroscopie Raman d'un échantillon de nanotubes obtenu selon un protocole de synthèse en co-injection en mode temporel basé sur l'injection d'une concentration constante en ferrocène au cours d'une seule et même séquence.

La figure 7 montre les rapports entre l'intensité de la bande D et l'intensité de la bande G ($I_D/I_G$) d'échantillons obtenus selon un protocole de synthèse en co-injection en mode temporel basé sur l'injection d'une concentration constante en ferrocène au cours d'une seule et même séquence.

La figure 8 représente un cliché observé en MET (microscopie électronique en transmission) d'un échantillon de nanotubes obtenu selon un protocole de synthèse en co-injection en mode temporel basé sur l'injection d'une concentration constante en ferrocène au cours d'une seule et même séquence.

Les figures 9a et 9b sont respectivement des histogrammes de distribution des diamètres externes et internes des nanotubes obtenus selon un protocole de synthèse en co-injection en mode temporel basé sur l'injection d'une concentration constante en ferrocène au cours d'une seule et même séquence.

Les figures 10a et 10b sont des clichés des nanotubes de carbone alignés d'un tapis obtenu selon un protocole de synthèse en co-injection en mode temporel basé sur l'injection à 800°C pendant 15 minutes d'un mélange toluène/ferrocène (10 % en poids) en présence d'un mélange gazeux Ar/$H_2$/$C_2H_2$ (0,70/0,30/0,03 L.min$^{-1}$) et observés respectivement en microscopie électronique à balayage (figure 10a) et en microscopie électronique en transmission (figure 10b).

Les figures 11a et 11b sont respectivement des histogrammes de distribution des diamètres externes et internes des nanotubes obtenus selon un protocole de synthèse en co-injection en mode temporel en présence d'un fluide réactif ($C_2H_2$).

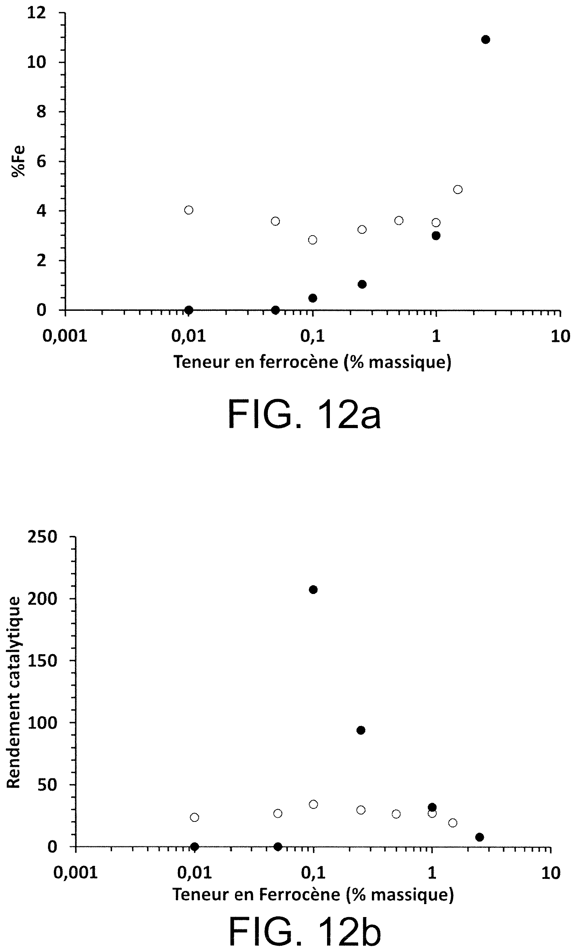

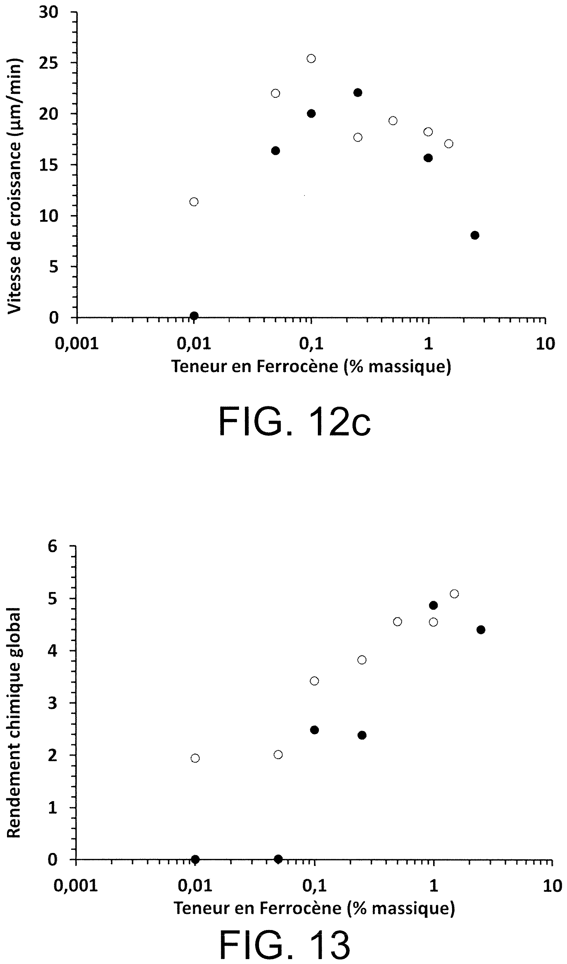

Les figures 12a, 12b et 12c représentent respectivement les variations de teneur en fer résiduel dans les échantillons (figure 12a), de rendement catalytique (figure 12b) et de vitesse de croissance (figure 12c) en fonction de la concentration en ferrocène mise en oeuvre selon un protocole de synthèse en co-injection en mode temporel, basé sur l'injection d'une concentration constante en ferrocène au cours d'une seule et même séquence (points noirs), et selon un mode de réalisation selon l'invention, c'est-à-dire une synthèse en mode spatial basée sur l'injection d'une concentration variable en ferrocène au cours de deux séquences temporelles (points blancs).

La figure 13 représente l'évolution du rendement chimique global en fonction de la concentration en ferrocène injecté pendant l'unique séquence de la synthèse en mode temporel illustrée dans les figures 12a à 12c (points noirs) et pendant la seconde séquence du mode de réalisation selon l'invention illustré dans les figures 12a à 12c (points blancs).

Les figures 14a et 14b représentent des clichés des nanotubes de carbone alignés d'un tapis obtenu selon un protocole de synthèse en mode temporel basé sur l'injection d'une concentration variable en ferrocène au cours de deux séquences temporelles et observés en microscopie électronique à balayage selon deux agrandissements différents.

La figure 15 représente un spectre typique obtenu par spectroscopie Raman d'un échantillon de nanotubes obtenu selon un protocole de synthèse en mode temporel basé sur l'injection d'une concentration variable en ferrocène au cours de deux séquences temporelles.

La figure 16 montre les rapports entre l'intensité de la bande D et l'intensité de la bande G ($I_D/I_G$) des échantillons obtenus selon un protocole de synthèse en mode temporel basé sur l'injection d'une concentration variable en ferrocène au cours de deux séquences temporelles.

La figure 17 représente un cliché observé en MET d'un échantillon de nanotubes obtenu selon un protocole de synthèse en mode temporel basé sur l'injection d'une concentration variable en ferrocène au cours de deux séquences temporelles.

Les figures 18a et 18b sont respectivement des histogrammes de distribution des diamètres externes et internes des nanotubes obtenus selon un protocole de synthèse en mode temporel basé sur l'injection d'une concentration variable en ferrocène au cours de deux séquences temporelles.

La figure 19 représente le profil d'injection des espèces dans les n zones selon un premier mode de réalisation de synthèse en mode spatial d'un tapis de nanotubes de carbone alignés en utilisant le dispositif et le procédé selon l'invention.

La figure 20 représente le profil d'injection des espèces dans les n zones selon un deuxième mode de réalisation de synthèse en mode spatial d'un tapis de nanotubes de carbone alignés en utilisant le dispositif et le procédé selon l'invention, le profil d'injection des espèces dans les n zones étant décomposé, pour des raisons de clarté, en profils d'injection dans les n zones pour chaque espèce injectée.

La figure 21 représente le profil d'injection des espèces dans les n zones selon un troisième mode de réalisation de synthèse en mode spatial d'un tapis de nanotubes de carbone alignés, dopés en leur milieu par de l'azote (présence de $NH_3$), en utilisant le dispositif et le procédé selon l'invention, le profil d'injection des espèces dans les n zones étant décomposé, pour des raisons de clarté, en profils d'injection dans les n zones pour chaque espèce injectée.

EP 3 068 725 B1

## EXPOSÉ DÉTAILLÉ DE MODES DE RÉALISATION PARTICULIERS

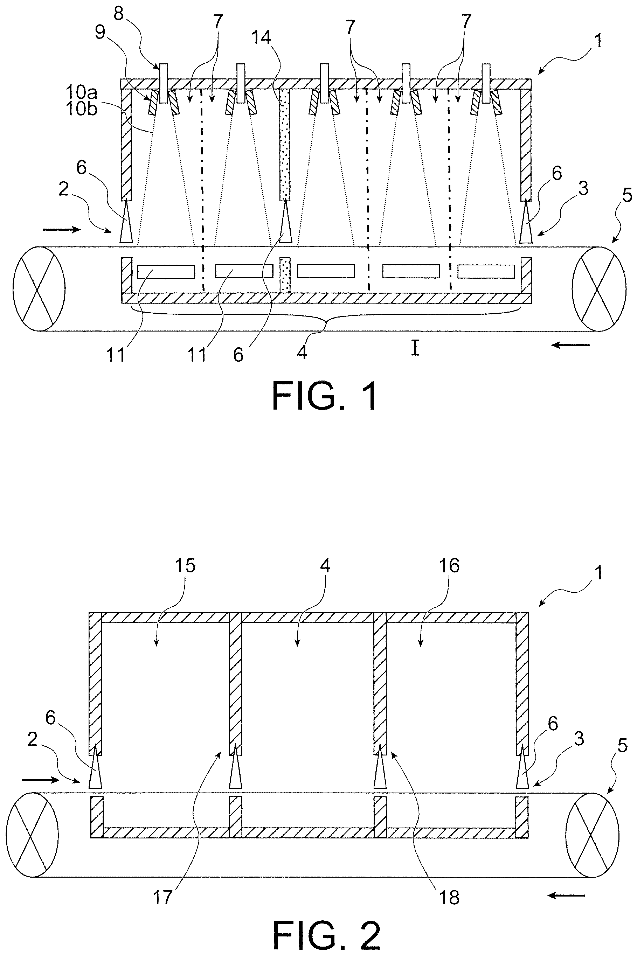

En référence tout d'abord à la figure 1, il est représenté un dispositif selon l'invention, formé d'une enceinte 1 comprenant une entrée 2 et une sortie 3 par lesquels un support (non représenté) peut entrer et sortir de l'enceinte. Des moyens de convoyage 5 permettent de faire défiler un support dans l'enceinte.

L'enceinte 1 comporte une chambre de réaction 4, qui est ici formée par tout l'espace interne de l'enceinte, et cette chambre de réaction est ici divisée en cinq zones 7 distinctes. Comme nous l'avons précisé plus haut, il est possible qu'une partie ou la totalité des zones soient séparées par une cloison ; dans la figure 1, nous avons représenté cinq zones dont deux zones adjacentes sont séparées par une cloison 14 ayant une ouverture munie de moyens de confinement 6 (tel que, par exemple, un gaz neutre injecté en tant que « gaz rideau ») (l'espace des autres zones non séparées par une cloison étant délimité par un trait discontinu).

Chaque zone est équipée d'un premier système d'injection 8 et éventuellement d'un deuxième système d'injection (non représenté). Le premier système d'injection 8 et le deuxième système d'injection permettent d'injecter respectivement un flux d'aérosol 10a et un flux d'au moins un fluide réactif 10b dans leur zone associée (le cône d'injection des flux 10a et 10b étant représenté par des lignes en pointillés), les injections étant de préférence déclenchées de manière continue et simultanée par des moyens de commande (non représentés) lorsque le support entre dans cette zone.

Il est à noter que par souci de simplification, seuls les injecteurs des premiers systèmes d'injection (injecteur débouchant dans la zone associée) ont été représentés dans la figure 1.

Chaque zone est également équipée d'un premier élément de chauffage 11, placé dans la partie basse de la zone et destiné à chauffer le support lors de son passage dans cette zone, et d'un deuxième élément de chauffage 9, placé dans la partie haute de la zone et destiné à chauffer les aérosols et fluides injectés dans la zone. Ici, le deuxième élément de chauffage 9 est placé directement à la sortie des premier et deuxième systèmes d'injection, de manière à chauffer les aérosols et fluides réactifs dès qu'ils rentrent dans la zone.

A la différence de la figure 1, le dispositif représenté dans la figure 2 comporte une enceinte ayant - en plus d'une chambre de réaction 4 - une chambre de pré-traitement 15 et une chambre de post-traitement 16, situées respectivement en amont et en aval de la chambre de réaction. La chambre de pré-traitement 15, la chambre de réaction 4 et la chambre de post-traitement 16 sont séparées par des cloisons comportant des ouvertures pour le passage du support. Dans la figure 2, on a disposé des moyens de confinement 6 du type gaz rideau au niveau de la sortie 17 de la chambre de pré-traitement 15 et de l'entrée 18 de la chambre de post-traitement 16. Pour des raisons de clarté, les n zones de la chambre de réaction 4, leurs premiers et deuxièmes éléments de chauffage, ainsi que leurs premiers et deuxièmes systèmes d'injection ne sont pas représentés.

Les moyens de convoyage peuvent par exemple être un tapis roulant. Dans les figures 1 et 2, les moyens de convoyage sont une bande convoyeuse sans fin montée sur deux rouleaux parallèles dont l'un au moins est entraîné en rotation.

Les premiers et deuxièmes éléments de chauffage peuvent par exemple être une pièce chauffante résistive (ayant par exemple la forme d'une plaque pour les premiers éléments et d'un cône pour les deuxièmes éléments, pour s'adapter à la forme des flux injectés), des moyens de chauffage rayonnant (lampes à infrarouges) ou un système inductif. De manière connue de l'homme du métier, la température dans chaque zone est choisie suffisante pour activer la croissance des nanostructures; comme cette température minimale dépend des espèces injectées dans la zone en question, il est particulièrement avantageux que chaque zone ait ses propres moyens de chauffage.

Les moyens de commande peuvent comporter au moins un capteur pour détecter la position du support par rapport à une zone et un actionneur qui déclenche l'injection.

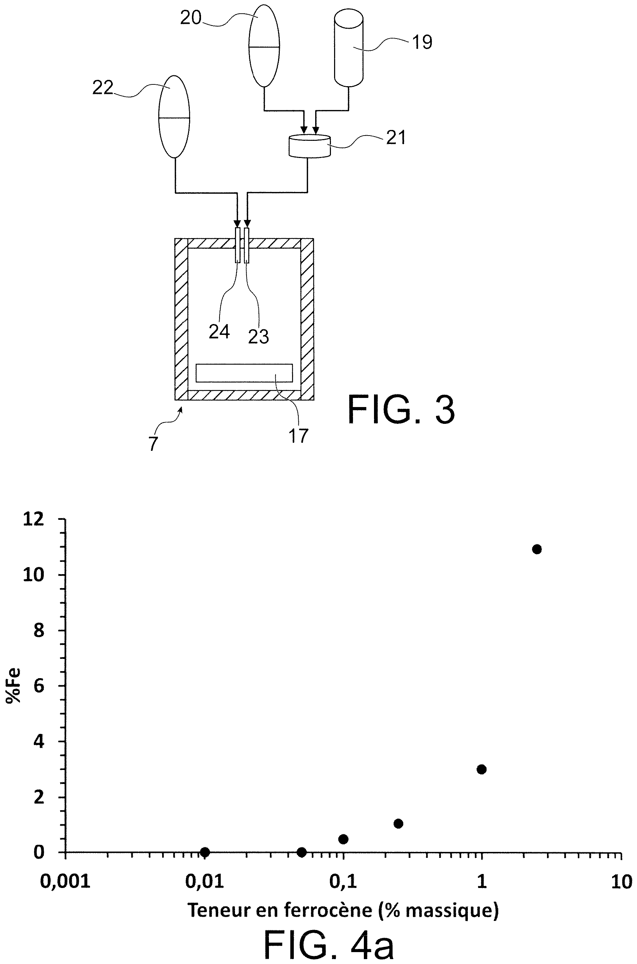

En référence à la figure 3, qui représente une zone 7, on peut voir un injecteur 23 du premier système d'injection, ainsi qu'un injecteur 24 du deuxième système d'injection, qui débouchent tous deux dans la partie haute de la zone 7.

De manière plus détaillée, le premier système d'injection est composé d'un injecteur 23, débouchant dans la zone 7, relié à un évaporateur 21, lui-même relié à un réservoir de liquide 19 et à un réservoir de gaz 20. Le premier système d'injection sert à injecter un aérosol. A cet effet, le réservoir de liquide contient une solution comprenant un précurseur catalytique et un précurseur source du matériau des nanostructures à fabriquer, par exemple un mélange de ferrocène et de toluène pour la réalisation de nanostructures en carbone, et le réservoir de gaz 20 contient un gaz porteur inerte, par exemple de l'argon. Le mélange liquide et le gaz se rejoignent dans l'évaporateur 21, dans lequel le mélange liquide est pulvérisé dans le gaz porteur sous forme de gouttelettes pour créer l'aérosol.

Le deuxième système d'injection permet d'injecter un flux d'un ou plusieurs fluides réactifs dans la zone. Le deuxième système d'injection comporte soit, lorsque le fluide est un liquide, un réservoir contenant le liquide, relié à un évaporateur, relié à un injecteur qui débouche dans la zone associé, soit, lorsque le fluide est un gaz, un réservoir 22 contenant le gaz, relié à un injecteur 24 qui débouche dans la zone associée.

Il est à noter que dans la figure 3, nous avons représenté un seul injecteur par système d'injection ; il est cependant possible que les systèmes d'injection comportent plusieurs injecteurs, l'injection se faisant de manière simultanée dans chacun de ces injecteurs.

Avec le dispositif et le procédé de fabrication selon l'invention, on peut réaliser des nanostructures alignées sur un support. On peut en particulier réaliser des nanotubes de carbone, des nanofils de silicium, des nanofils d'oxyde de titane ($TiO_2$), d'oxyde de zinc (ZnO) ou de bisulfure de tungstène $WS_2$.

Dans les exemples de réalisation qui vont suivre, nous allons décrire des modes opératoires pour la fabrication de tapis de nanotubes de carbone alignés.

Dans un premier temps, nous allons mesurer les caractéristiques de la synthèse (rendements) et des nanotubes ainsi obtenus (pureté, vitesse de croissance, etc.), pour déterminer les gammes de paramètres de synthèse optimales. Ces mesures vont être réalisées à partir d'un tapis dense en nanotubes de carbone alignés, obtenu selon un protocole de synthèse en co-injection, basé sur une ou plusieurs séquence(s) temporelle(s) réalisée(s) sur un substrat immobile (exemples 1a, 1b et 1c ci-dessous).

Puis, nous définirons les protocoles de synthèse optimums en passant du mode temporel (substrat immobile) vers le mode spatial (substrat défilant) (exemples 2 à 4). Ces exemples 2 à 4 vont être obtenus en utilisant le dispositif selon l'invention, qui est représenté dans la figure 1, c'est-à-dire un dispositif dans lequel l'enceinte et la chambre de réaction sont un seul et même élément, et dans lequel la chambre de réaction est divisée en cinq zones. Les cinq zones sont chacune équipées d'un premier système d'injection et d'un deuxième système d'injection, d'un premier élément de chauffage disposé dans le bas de chaque zone et destiné à chauffer le support, et un deuxième élément de chauffage disposé à la sortie des injecteurs des premier et deuxième systèmes d'injection et destiné à chauffer les flux sortant de ces deux systèmes. Il est à noter que la cloison 14 est optionnelle.

Pour la réalisation de nanotubes de carbone, divers gaz carbonés peuvent être utilisés comme source carbonée (hydrocarbures, alcools, monoxyde de carbone, halogénures de carbone, etc.) ; la source carbonée peut aussi être sous forme liquide (toluène, cyclohexane, huiles d'origine végétale (camphre, eucalyptus, etc.)) ou solide et être utilisée pure, lorsqu'elle est sous forme liquide, ou dissoute dans un solvant lorsqu'elle est sous forme liquide ou solide. Cette source carbonée peut également contenir des hétéroatomes tels que l'azote ou le bore (benzylamine, acétonitrile, etc.).

Comme précurseur métallique, on peut utiliser un métallocène de métal de transition.

Le gaz porteur peut être un gaz inerte ou réactif; il peut par exemple s'agir d'argon (Ar) ou d'hélium (He).

Les fluides réactifs injectés par le deuxième système d'injection peuvent être liquides ou gazeux; il peut s'agir d'eau ($H_2O$), d'acétylène ($C_2H_2$), d'azote ($N_2$), d'ammoniac ($NH_3$), de dioxyde de carbone ($CO_2$), d'éthylène ($C_2H_4$), d'hydrogène ($H_2$) ou de tout autre précurseur d'hétéroatome (type Bore ou Phosphore, par exemple).

Comme support pour faire croître les nanostructures, on peut utiliser un large choix de substrats. On peut par exemple choisir un substrat plan en quartz ou en silicium ou bien encore un substrat plan métallique, tel qu'un substrat en acier ou en aluminium ; on peut également utiliser des substrats poreux, tels que des tissus fibreux, des membranes en céramique poreuse, des grilles métalliques, etc. Il est à noter que le choix du précurseur de source carbonée, le choix du précurseur catalytique et le choix du fluide réactif doivent tenir compte de la température de tenue thermique du support choisi.

Dans la description des modes opératoires qui vont suivre, nous allons utiliser du toluène comme précurseur de source carbonée, du ferrocène comme précurseur catalytique, de l'argon comme gaz porteur, du quartz comme support et, le cas échéant de l'hydrogène ou de l'acétylène comme fluide réactif.

La synthèse de nanotubes de carbone alignés par CVD est connue de l'homme du métier et n'est pas décrite en détails ici. Dans les n zones, la synthèse CVD se fait de manière classique, à savoir à une température comprise entre 550 et 1100 °C (de préférence entre 550 et 850°C) et à une pression comprise entre 10 mbar et 1 atm pour la croissance de nanotubes de carbone, de préférence à une pression comprise entre 900 mbar et 1 atm.

**Exemples 1a, 1b et 1c - Réalisation et caractérisation d'un tapis dense en nanotubes de carbone alignés, obtenu selon un protocole de synthèse basé sur une ou plusieurs séquences temporelles (substrat immobile)**

Dans cet exemple, on utilise une enceinte CVD dont la chambre de réaction est un tube en quartz disposé horizontalement dans laquelle un substrat immobile est positionné avant la croissance des nanostructures (typiquement un dispositif de laboratoire tel que décrit dans le document **[7]**).

Le mélange de précurseurs (catalytique + source) nécessaire à la croissance des nanostructures est injecté séquentiellement dans le temps, chacune des séquences se caractérisant par une concentration différente en précurseur catalytique dans le cas où il y a au moins deux séquences.

Les exemples 1a, 1b et 1c ci-dessous vont nous permettre de mesurer les caractéristiques à la fois de la synthèse (rendements) et des nanotubes ainsi obtenus (pureté, vitesse de croissance, diamètres, etc.) et de déterminer les gammes de paramètres de synthèse optimales.

**Exemple 1a** : injection d'une concentration constante en ferrocène au cours d'une seule et même séquence

Les figures 4a à 9b font état des résultats obtenus en injectant continûment en une seule séquence une concentration constante en ferrocène dans le mélange toluène/ferrocène avec, en particulier, l'effet de différentes concentrations en ferrocène (entre 0,01 et 2,5 % en poids pour les différentes synthèses, avec respectivement 0,01, 0,05, 0,1, 0,25, 1, 2,5 % en poids pour les échantillons 1 à 6) sur les caractéristiques du procédé et des nanotubes obtenus.

Les nanotubes sont synthétisés à une température de 800°C en utilisant un mélange argon/$H_2$ (70/30 % vol) en tant que gaz porteur, pendant une durée de 15 minutes.

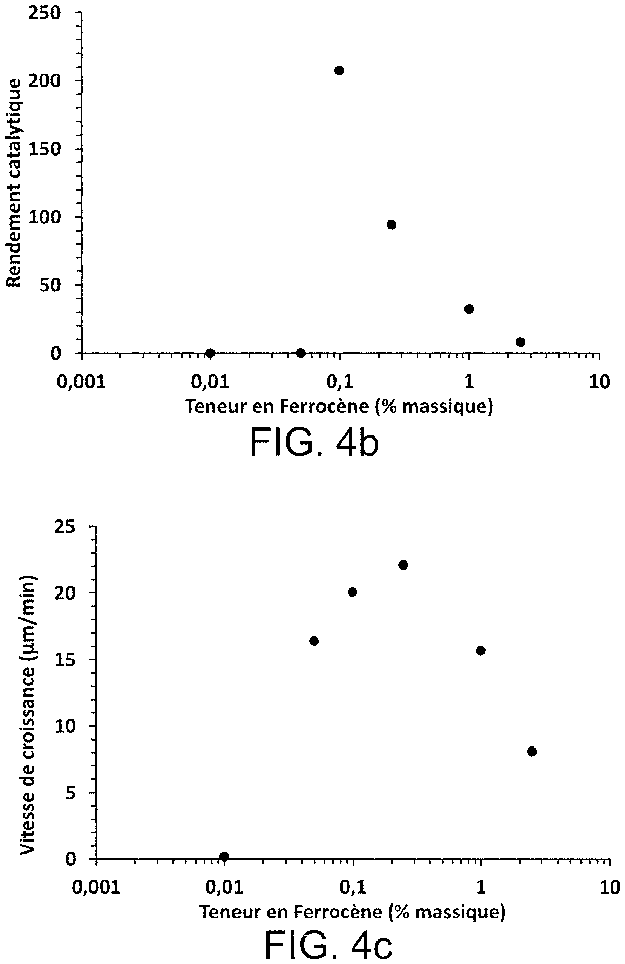

Les figures 4a, 4b et 4c représentent respectivement les variations de teneur en fer résiduel dans les échantillons (figure 4a), de rendement catalytique (figure 4b) et de vitesse de croissance (figure 4c) en fonction de la concentration en ferrocène mise en oeuvre.

La teneur en fer est mesurée par analyse thermogravimétrique (ATG) sous air : le carbone, constituant des nanotubes, est oxydé, libérant ainsi des espèces carbonées volatiles, alors que le fer résiduel est oxydé sous forme de poudre $Fe_2O_3$, la mesure de sa masse par ATG permettant de calculer sa proportion dans l'échantillon.

Le rendement catalytique est calculé selon la formule :

$$R_{catalytique} = (m_C/m_{Fe})$$

$m_C$ étant la masse de carbone dans l'échantillon et $m_{Fe}$ étant la masse de fer dans l'échantillon.

La vitesse de croissance est obtenue en mesurant, par microscopie électronique à balayage, la longueur des nanotubes obtenus et en divisant cette valeur par la durée de synthèse.

La figure 4a montre que la teneur en fer résiduel dans les échantillons est d'autant plus faible que la teneur en ferrocène injecté est faible.

En revanche, le rendement catalytique (figure 4b) suit une évolution non monotone avec la concentration en ferrocène et, de manière surprenante, un rendement catalytique extrêmement élevé et maximum est obtenu pour une concentration en ferrocène de 0,1 % en poids, alors qu'au-delà, le rendement diminue significativement.

A la lecture de la figure 4c, on constate que la vitesse de croissance augmente significativement jusqu'à une concentration en ferrocène de 0,25 % en poids, puis chute rapidement pour atteindre des valeurs relativement faibles (de l'ordre de 8 $\mu$m/min pour 2,5 % en poids de ferrocène).

En conclusion, on constate qu'on obtient des résultats particulièrement intéressants pour une teneur en ferrocène de 0,1 % en poids (très bon rendement catalytique, grande pureté et vitesse de croissance supérieure à 20 $\mu$m/min).

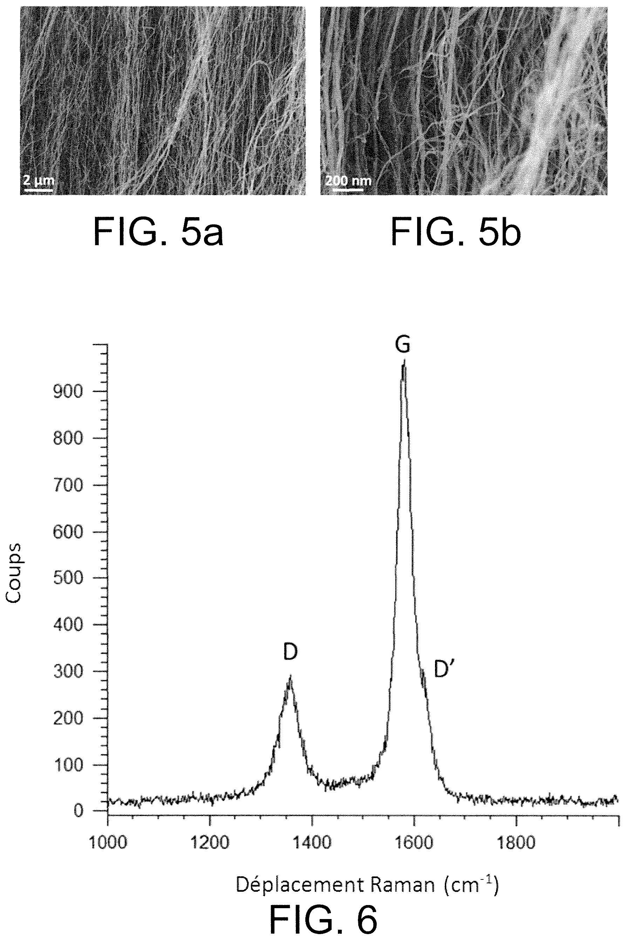

Les figures 5a et 5b montrent l'allure typique des nanotubes observés par MEB (microscopie électronique à balayage), quelle que soit la concentration en ferrocène injecté pour les échantillons 2 à 5 (0,05 % à 1 % en poids). On constate que les nanotubes de carbone obtenus sont alignés et contiennent très peu d'impuretés (particules à base de catalyseur (fer) résiduel, particules de carbone désorganisé). En fait, très peu d'impuretés ont pu être observées, exceptée pour les produits issus de la concentration en ferrocène de 2,5 % en poids (échantillon 6), pour lesquelles des particules à base de catalyseurs résiduels ont pu être observées. Pour l'échantillon 1 (0,01 % en poids), la vitesse de croissance des nanotubes est proche de 0 et nous n'avons pu obtenir de clichés.

Dans la figure 6 est présenté un spectre typique obtenu par spectroscopie Raman à une longueur d'onde incidente de 532 nm et qui met en évidence la présence des bandes G, D et D', dont les positions sont caractéristiques des nanotubes de carbone.

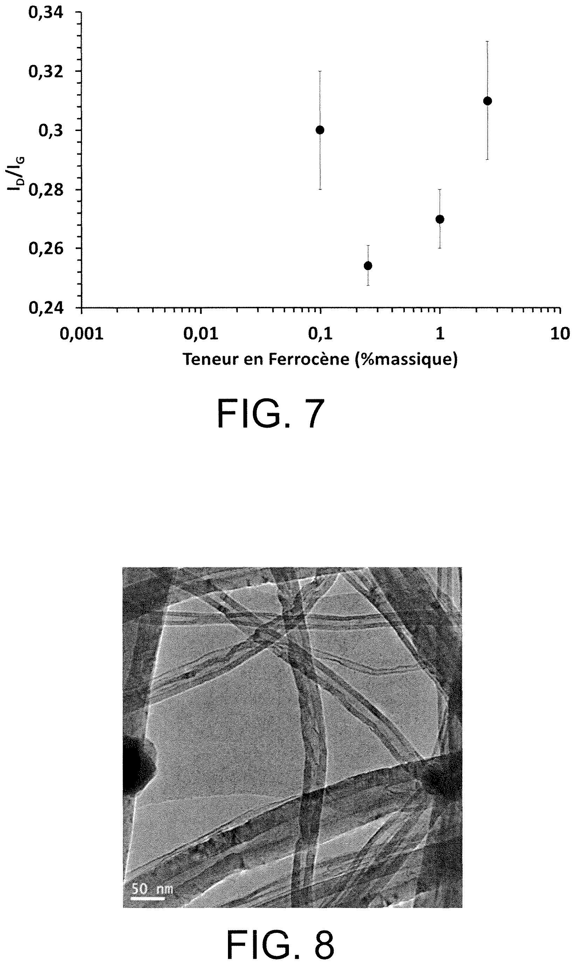

La figure 7 montre les rapports entre l'intensité de la bande D et l'intensité de la bande G ($I_D/I_G$) des échantillons 3 à 6. Selon la littérature, il est admis que plus ce rapport est élevé et plus la structure des nanotubes est défectueuse. En particulier, beaucoup de nanotubes multi-feuillets obtenus par CVD présentent un rapport de l'ordre de 0,8 et 1. Pour les échantillons 3 à 6, on constate que le rapport est beaucoup plus bas (de l'ordre de 0,3) et n'est que très peu modifié par la concentration en ferrocène injecté, indiquant une bonne qualité structurale des nanotubes ainsi produits.

La figure 8 représente un cliché observé en MET (microscopie électronique en transmisssion) d'un échantillon de nanotubes mettant en évidence la formation de nanotubes multi-feuillets présentant très peu d'impuretés, ce qui est le cas en particulier pour l'échantillon 3 obtenu avec une concentration de 0,1 % en poids en ferrocène. Pour l'échantillon 6 obtenu avec une concentration de 2,5 % en poids en ferrocène, des impuretés telles que des particules à base de fer résiduel ont été observées.

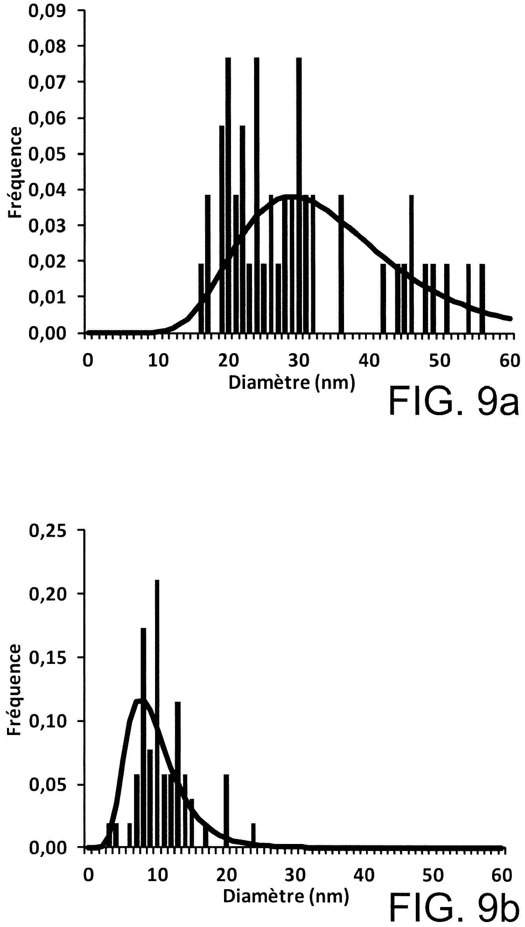

Les diamètres externes et internes mesurés sur la base de ce cliché sont présentés dans les histogrammes en figures 9a et 9b, le diamètre externe moyen (figure 9a) étant de l'ordre de 30 nm et le diamètre interne moyen (figure 9b) étant de 9 nm. Ces mesures ont également été réalisées sur les autres échantillons (à l'exception de l'échantillon 1), ce qui a permis de constater que les nanotubes obtenus ont les mêmes diamètres interne et externe moyens quelle que soit la concentration en ferrocène injecté.

**Exemple 1b : injection d'une concentration constante en ferrocène au cours d'une seule et même séquence en présence d'un fluide réactif (acétylène).**

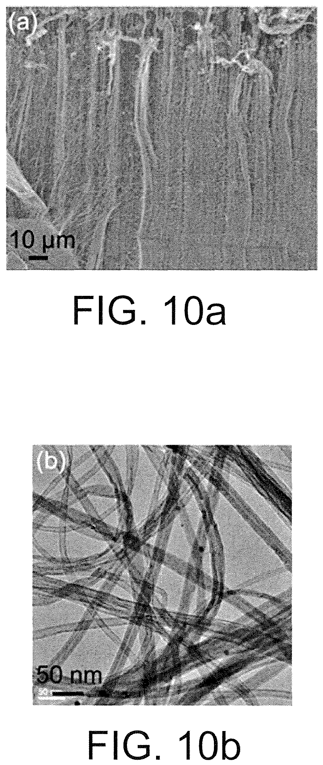

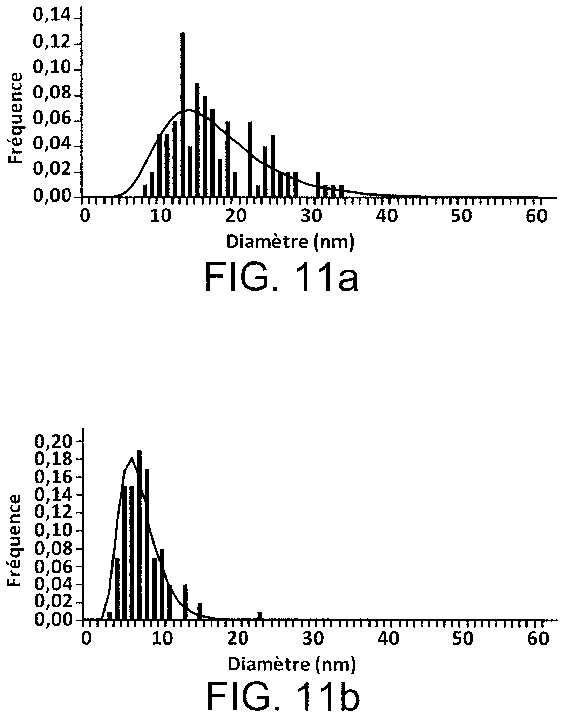

Les figures 10a-b et 11a-b font état des résultats obtenus en injectant continûment en une seule séquence une concentration constante en ferrocène dans le mélange toluène/ferrocène (10 % en poids) avec, en particulier, l'effet du fluide réactif (acétylène) sur les caractéristiques du procédé et des nanotubes obtenus.

Les nanotubes sont synthétisés à une température de 800°C en utilisant un mélange gazeux $Ar/H_2/C_2H_2$ (0,70/0,30/0,03 L.min$^{-1}$) avec Ar en tant que gaz porteur et $H_2$ /$C_2H_2$ en tant que fluide réactif, pendant une durée de 15 minutes.

La figure 10a illustre la morphologie des nanotubes observés par MEB (microscopie électronique à balayage) en surface du support en quartz. On observe que les nanotubes de carbone obtenus sont alignés, longs et contiennent très peu d'impuretés (particules à base de catalyseur (fer) résiduel, particules de carbone désorganisé).

La vitesse de croissance est obtenue en mesurant, par microscopie électronique à balayage, la longueur des nanotubes obtenus et en divisant cette valeur par la durée de synthèse. A la lecture de la figure 10a, on constate que la vitesse de croissance atteint 16,6 $\mu$m/min en présence d'acétylène, soit une valeur nettement supérieure à celle reportée à la figure 4c pour une concentration élevée en ferrocène, mais en l'absence d'acétylène.

La figure 10b représente un cliché observé en MET (microscopie électronique en transmission) de ces nanotubes mettant en évidence la formation de nanotubes de carbone multi-feuillets présentant peu d'impuretés dans le coeur central ou à l'extérieur des nanotubes ; seules des impuretés telles que des particules à base de fer résiduel ont été observées. Les diamètres externes mesurés sur la base de ces clichés MET sont présentés dans les histogrammes des figures 11a et 11b. Le diamètre externe moyen (figure 11a) est de l'ordre de 18 nm, soit sensiblement plus faible que le diamètre externe moyen obtenu en l'absence de fluide réactif, et le diamètre interne moyen (figure 11b) est de l'ordre de 7 nm. La teneur en fer résiduel mesurée par ATG est de 3,9% en poids.

**Exemple 1c : injection d'une concentration variable en ferrocène au cours de deux séquences temporelles**

Les points blancs dans les figures 12a-c, 13, 16 et les figures 14a-b, 15, 175, 18a-b font état des résultats obtenus en injectant, au cours de la première séquence, une solution contenant 2,5 % en poids de ferrocène dans le mélange toluène/ferrocène, la durée de synthèse étant de 1 min 40, puis en injectant, au cours d'une seconde séquence, une solution contenant une concentration en ferrocène plus faible, que l'on fait varier dans la gamme [0,01- 1,25] % en poids pour les différentes synthèses (respectivement 0,01, 0,05, 0,1, 0,25, 0,5, 1, 1,5 % en poids pour les échantillons a à g), la durée de synthèse étant de 13 min 20.

L'effet des différentes concentrations en ferrocène injecté dans la seconde séquence sur les caractéristiques du procédé et des nanotubes obtenus sont présentés dans les figures qui suivent.

Pour les deux séquences, la température de croissance est fixée à 800°C et le gaz porteur est un mélange argon/$H_2$ (70/30 % vol), la durée de synthèse cumulée sur les deux séquences étant de 15 minutes.

Pour comparaison, les résultats obtenus à l'exemple 1a par injection d'une concentration constante en ferrocène au cours d'une seule séquence sont également présentés (représentés par des points noirs).

Les figures 12a, 12b et 12c représentent respectivement les variations de teneur en fer résiduel dans les échantillons (figure 12a), de rendement catalytique (figure 12b) et de vitesse de croissance (figure 12c) en fonction de la concentration en ferrocène mise en oeuvre au cours de la seconde séquence (points blancs) ou au cours d'une seule séquence (points noirs).

La teneur en fer est mesurée par analyse thermogravimétrique (ATG) sous air.

Le rendement catalytique est calculé comme développé ci-dessus.

La figure 12a montre que la teneur en fer résiduel dans les échantillons a à g est faible et se situe autour de 4 % en poids avec toutefois un minimum situé à 2,8 % en poids pour une concentration en ferrocène injecté pendant la seconde séquence de 0,1 % en poids de ferrocène.

La figure 12b montre quant à elle que le rendement catalytique reste situé entre 20 et 35, avec un optimum situé à 35 pour une concentration en ferrocène de 0,1 % en poids injectée au cours de la seconde séquence. Comparativement à une injection d'une concentration faible et constante en ferrocène au cours d'une seule et même séquence (points noirs), l'injection de concentrations différentes selon deux séquences successives conduit à une diminution du rendement catalytique et à une augmentation de la teneur en fer résiduel, en restant toutefois dans une gamme de teneurs correcte en termes de pureté de produits.

La figure 12c montre l'évolution de la vitesse de croissance en fonction de la concentration en ferrocène injecté au cours de la seconde séquence ou en une seule et même séquence. La vitesse de croissance est obtenue selon la méthode décrite ci-dessus dans l'exemple 1a.

On constate que la vitesse de croissance augmente lorsque la teneur en ferrocène injecté pendant la seconde séquence augmente jusqu'à une teneur de 0,1 % en poids, puis diminue. Cette évolution est identique à celle mesurée dans le cas d'une injection de concentration constante en une seule et même séquence (exemple 1a), même si, dans l'exemple 1a, le maximum de la vitesse de croissance se situe à 0,25 % en poids de ferrocène. Toutefois, la vitesse de croissance reste globalement plus élevée dans le cas où la concentration en ferrocène varie selon les séquences (exemple 1c).

La figure 13 représente l'évolution du rendement chimique global en fonction de la concentration en ferrocène injecté pendant la seconde séquence (points blancs) ou pendant une seule et même séquence (points noirs).

Le rendement chimique global (exprimé en %) est le résultat du rapport entre la masse totale de produit obtenu et la masse totale de précurseur injecté, multiplié par 100.

On constate que le rendement chimique global augmente lorsque la concentration en ferrocène augmente pendant la seconde séquence et reste globalement toujours plus élevé comparativement à une injection d'une concentration constante de ferrocène pendant une seule et même séquence.

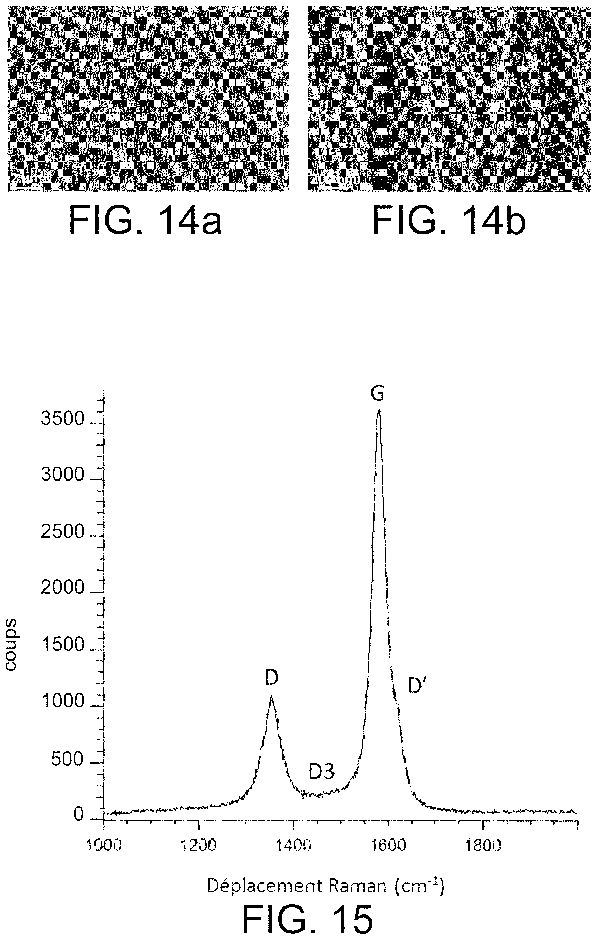

Les figures 14a et 14b montrent l'allure typique des nanotubes observés par MEB, quelle que soit la concentration en ferrocène injecté lors de la seconde séquence pour les échantillons a à g (0,01 % à 1,5 % en poids). On constate que les nanotubes de carbone obtenus sont alignés et contiennent très peu d'impuretés (particules à base de catalyseur (fer) résiduel, particules de carbone désorganisé). En fait, très peu d'impuretés ont pu être observées dans les échantillons a à g.

Dans la figure 15 est présenté un spectre typique obtenu par spectroscopie Raman à une longueur d'onde incidente de 532 nm et qui met en évidence la présence des bandes G, D et D', dont les positions sont caractéristiques des nanotubes de carbone.

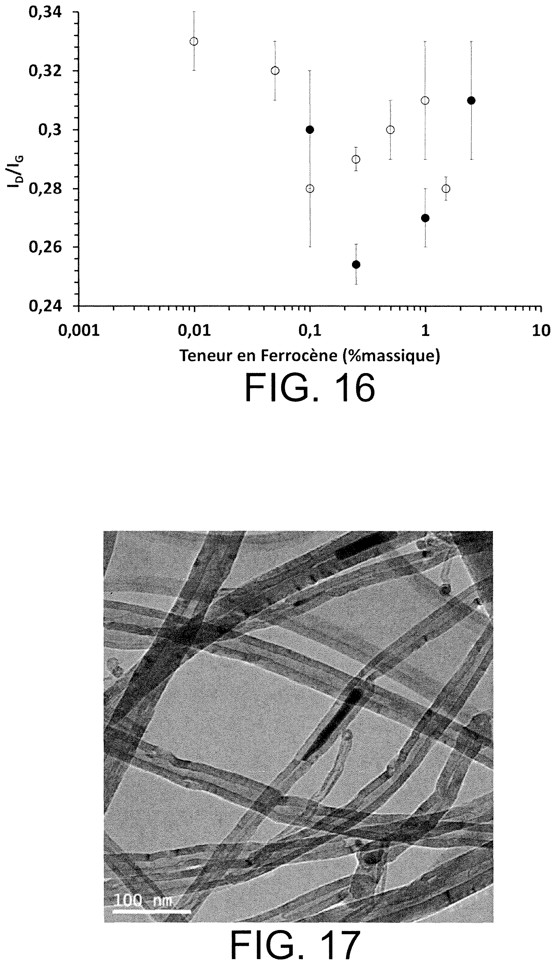

La figure 16 montre les rapports entre l'intensité de la bande D et l'intensité de la bande G ($I_D/I_G$) des échantillons a à g (points blancs) et, pour comparer, nous avons également introduit les rapports obtenus à l'exemple 1a pour les échantillons 3 à 6 (points noirs). On constate que, pour les échantillons a à g, on obtient un rapport de l'ordre de 0,3, ce qui indique une bonne qualité structurale des nanotubes produits. Ce rapport diminue lorsque la concentration en ferrocène injecté au cours de la seconde séquence augmente jusqu'à 0,1 % en poids, puis augmente à nouveau lorsque la concentration en ferrocène augmente.

Si l'on compare les rapports obtenus à l'exemple 1a (concentration en ferrocène constante injecté en une seule et même séquence) et à l'exemple 1c (concentration en ferrocène variable injectée selon deux séquences), on constate que le rapport reste globalement dans le même ordre de grandeur quelle que soit la façon d'injecter le ferrocène.

La figure 17 représente un cliché observé en MET d'un échantillon de nanotubes mettant en évidence la formation de nanotubes multi-feuillets présentant très peu d'impuretés, ce qui est le cas en particulier pour l'échantillon c obtenu avec une concentration de 0,1 % en poids en ferrocène.

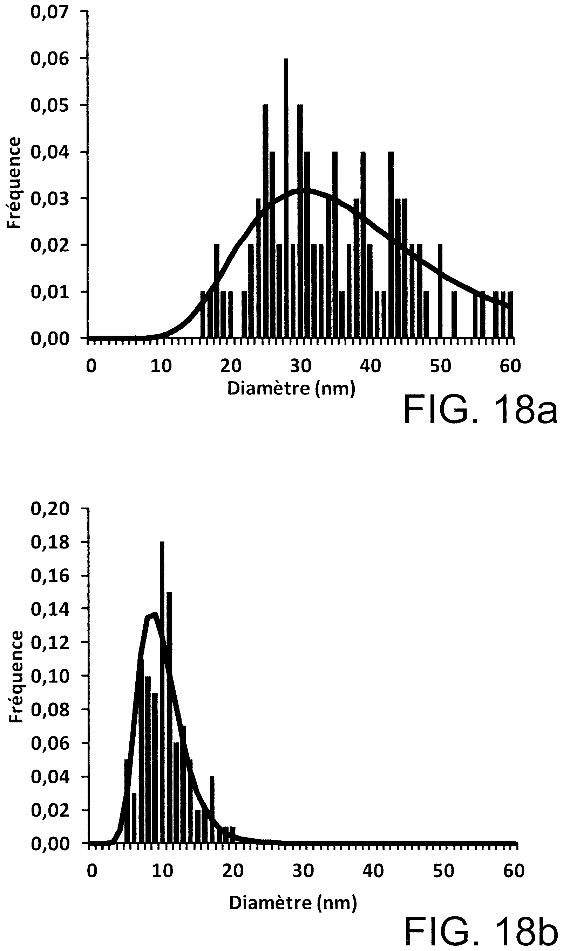

Les diamètres externes et internes mesurés sur la base de ce cliché sont présentés dans les histogrammes en figures 18a et 18b, le diamètre externe moyen (figure 18a) étant de l'ordre de 30 nm et le diamètre interne moyen (figure 18b) étant de l'ordre de 9 nm. Ces mesures ont également été réalisées sur les autres échantillons, ce qui a permis de constater que les nanotubes obtenus ont les mêmes diamètres interne et externe moyens quelle que soit la concentration en ferrocène injecté pendant la seconde séquence.

A partir de ces exemples 1a, 1b et 1c et en se basant sur les constatations scientifiques concernant les effets de concentration en ferrocène injecté au cours du temps selon un mode en une seule séquence (concentration en ferrocène constante au cours du temps) ou en plusieurs séquences successives (concentration en ferrocène variable au cours du temps), les inventeurs ont élaboré des nouveaux protocoles de synthèses en transposant ces séquences temporelles en des séquences spatiales. L'un des avantages du dispositif et du procédé selon l'invention est que, en fonction de ce qui est souhaité en termes de production (rendement chimique global et vitesse de croissance élevés ou rendement catalytique élevé), il est possible d'ajuster la mise en oeuvre du procédé en jouant sur le profil d'injection spatial des précurseurs selon les n zones du dispositif.

**Exemple 2 - Mode opératoire pour la réalisation d'un tapis de nanotubes de carbone alignés selon une synthèse séquentielle en mode spatial ayant un profil d'injection des espèces dans les n zones à deux séquences d'injection différentes (substrat défilant).**

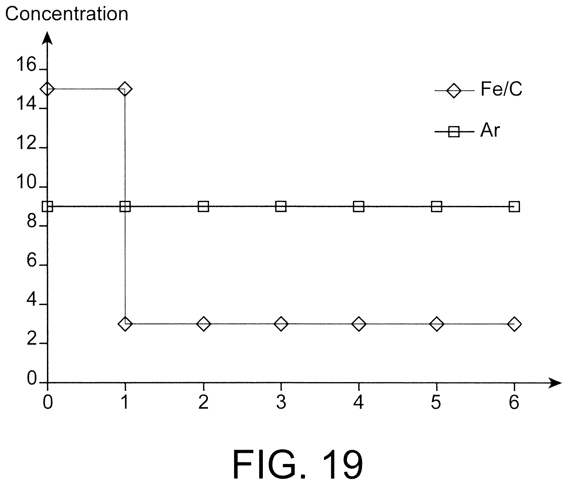

Selon le principe de l'invention, le support traverse n zones dans lesquelles règnent des conditions de croissance locales, au moins deux de ces n zones ayant des conditions de croissances qui diffèrent au moins par la concentration du précurseur catalytique présent dans l'aérosol qui est injecté. Plus particulièrement, la figure 19 représente un profil d'injection des espèces dans les n zones selon un mode de réalisation préféré de l'invention, où l'on injecte un aérosol comprenant une forte concentration en ferrocène dans la première zone de la synthèse (première séquence d'injection), puis on diminue fortement cette concentration dans les zones suivantes (seconde séquence).

Dans la figure 19, le profil d'injection des espèces dans les n zones comporte deux séquences d'injection ; pour retranscrire ce profil d'injection, il faut utiliser un dispositif CVD dont la chambre de réaction comporte au moins deux zones présentant des conditions de croissance locales différentes. Dans notre exemple, la première séquence d'injection va être réalisée dans la première zone et la deuxième séquence d'injection aura lieu dans les quatre autres zones.

Comme nous l'avons dit précédemment, le choix de la dimension des zones dans le sens de convoyage dépend de la vitesse de déplacement des moyens de convoyage, ainsi que de la durée d'injection d'une séquence d'injection. Il est également possible, au lieu d'utiliser une seule zone pour une séquence d'injection, d'en utiliser plusieurs, chacune de ces zones ayant alors les mêmes conditions locales de croissance.

Pendant la durée de la première séquence d'injection, on injecte une solution de toluène comprenant du ferrocène selon une concentration d'au moins 2,5 % en poids, ce qui permet de diminuer le diamètre des nanoparticules et d'augmenter la densité des nanoparticules qui servent à la germination des nanotubes en comparaison avec une concentration faible (≤0,5 % en poids), afin d'obtenir un tapis de nanotubes plus fin en épaisseur et plus dense.

Pour la seconde séquence d'injection, on injecte une solution de toluène comprenant du ferrocène et dans laquelle la concentration en ferrocène est plus faible que dans la première injection (la concentration en ferrocène dans la solution étant inférieure ou égale à 1 % massique, de préférence inférieure ou égale à 0,5 %, préférentiellement inférieure ou égale à 0,25 %). Cette diminution drastique de la concentration en ferrocène permet de diminuer la présence résiduelle de fer au coeur des nanotubes (figure 12a). Ce choix a aussi pour effet d'augmenter le rendement chimique global de synthèse des nanotubes (figure 13).

Les composés et les quantités relatives injectés dans les cinq zones sont résumés dans le tableau 1 ci-dessous. Il est à noter que les valeurs exactes à injecter ne sont pas indiquées, car elles doivent être ajustées en fonction de nombreux facteurs, comme la taille des substrats et leurs surfaces spécifiques, la taille des n zones, la vitesse de défilement du support et des caractéristiques du tapis que l'on souhaite obtenir.

Tableau 1

| Séquence 1 (0-1) | Séquence 2 (1-5) | | | |
|---|---|---|---|---|
| Zone 1 | Zone 2 | Zone 3 | Zone 4 | Zone 5 |
| [Ferrocène] (% élevé) [Ar] | [Ferrocène] (% faible) [Ar] | [Ferrocène] (% faible) [Ar] | [Ferrocène] (% faible) [Ar] | [Ferrocène] (% faible) [Ar] |

Dans cet exemple de mode opératoire, nous avons choisi d'avoir cinq zones de mêmes dimensions.

En référence à la figure 19, la première séquence correspond au laps de temps 0-1 sur l'échelle de temps et correspond au temps passé par le support dans la zone 1 (typiquement de 1 à 2 minutes) ; les laps de temps 1-2, 2-3, 3-4, 4-5 correspondent respectivement aux temps passés par le support dans les zones 2, 3, 4, 5, les mêmes espèces et en quantités identiques étant injectées dans les 2ème à 5ème zones, qui correspondent à la deuxième séquence (laps de temps 1-5).

**Exemple 3 - Mode opératoire pour la réalisation d'un tapis de nanotubes de carbone alignés selon une synthèse séquentielle en mode spatial à trois séquences d'injection différentes (substrat défilant).**

Dans cette synthèse, on a recours à différents gaz porteurs au cours de la synthèse, à savoir l'argon et l'hélium, ce qui va nous permettre de favoriser l'élaboration de tapis de nanotubes ayant une plus grande densité de nanotubes et des nanotubes de plus petits diamètres par rapport à la synthèse précédente.

Dans cet exemple de synthèse, on illustre également la possibilité d'injecter un fluide réactif (ici le dihydrogène). Nous avons ici choisi d'utiliser du dihydrogène, mais nous aurions pu choisir d'injecter de l'acétylène, par exemple.

Cette synthèse séquentielle comporte trois séquences d'injection ; il faut donc que la chambre de réaction ait au minimum trois zones. Comme dans l'exemple précédent, on peut donc utiliser une enceinte CVD dont la chambre de réaction est divisée en cinq zones, comme illustré dans la figure 1.

Les composés et les quantités injectés dans les cinq zones sont résumés dans le tableau 2 ci-après.

Tableau 2

| Séquence 1 (0-1) | Séquence 2 (1-2) | Séquence 3 (2-5) | | |
|---|---|---|---|---|
| Zone 1 | Zone 2 | Zone 3 | Zone 4 | Zone 5 |
| [Ferrocène] (% élevé) [Ar] | [Ferrocène] (% faible) [Ar] | [Ferrocène] (% faible) [Ar] | [Ferrocène] (% faible) [Ar] | [Ferrocène] (% faible) [Ar] |

(suite)

| Séquence 1 (0-1) | Séquence 2 (1-2) | Séquence 3 (2-5) | | |
|---|---|---|---|---|
| Zone 1 | Zone 2 | Zone 3 | Zone 4 | Zone 5 |
| $[H_2]$ (% élevé) | $[H_2]$ (% faible) [He] | | | |

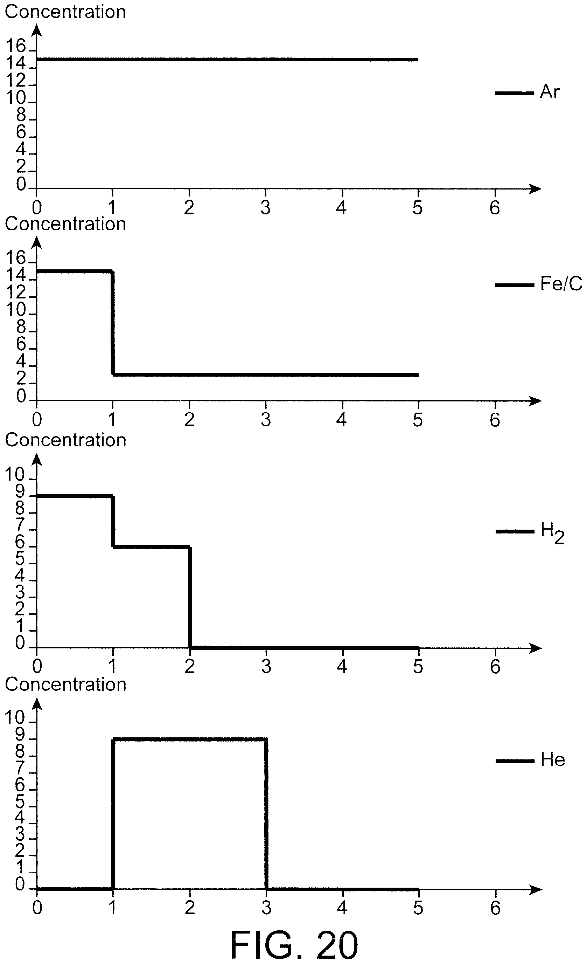

En référence à la figure 20, on peut voir que, tout au long de la première séquence d'injection, on injecte une solution de toluène et de ferrocène, la concentration en ferrocène étant supérieure ou égale à 10 % en poids dans une atmosphère réactionnelle concentrée en dihydrogène (typiquement un pourcentage volumique compris entre 5 et 60 %). Cette injection de dihydrogène a pour effet de diminuer la température de décomposition du ferrocène et, par conséquent, la température de synthèse des nanotubes.

Dans la deuxième séquence d'injection, on injecte une solution présentant une faible concentration en ferrocène, la concentration en ferrocène dans la solution étant inférieure ou égale à 1 % en poids, de préférence inférieure ou égale à 0,5 % en poids, préférentiellement inférieure ou égale à 0,25 % en poids. En outre, on injecte une plus faible quantité de dihydrogène par rapport à la séquence précédente et on injecte un autre gaz neutre, comme par exemple de l'hélium (ou un surplus d'argon). Cela a pour effet de jouer aussi sur la température de synthèse des nanotubes, du fait des capacités calorifiques des gaz employés.

Dans la troisième séquence d'injection, on injecte une solution ayant une faible concentration en ferrocène dans une atmosphère standard tout argon, ce qui permet de revenir aux conditions de synthèse initiale.

**Exemple 4 - Mode opératoire pour la réalisation d'un tapis dense de nanotubes de carbone dopés alignés selon une synthèse séquentielle en mode spatial à cinq séquences d'injection différentes (substrat défilant).**

Dans cette synthèse, en plus des espèces injectées dans l'exemple 3, on va en outre injecter une faible quantité d'eau et un précurseur comportant un hétéroatome tel que l'azote, par exemple de l'ammoniac (pourcentage volumique d'eau compris entre 0,0001 % et 0,1 % et pourcentage volumique d'ammoniac compris entre 0,001 % et 60 %) afin de réaliser un tapis de nanotubes alignés dopés sur tout ou partie de leur hauteur et dans lequel le tapis de nanotubes se décolle plus facilement du substrat que si l'on n'avait pas injecter d'eau. A noter que cet exemple de synthèse a un but illustratif et en particulier il n'y a aucune corrélation entre l'injection d'eau (sous forme de vapeur) et d'ammoniac.

Les composés et les quantités injectés dans les cinq zones sont résumés dans le tableau 3 ci-dessous.

Tableau 3

| Séquence 1 (0-1) | Séquence 2 (1-2) | Séquence 3 (2-3) | Séquence 4 (3-4) | Séquence 5 (4-5) |
|---|---|---|---|---|
| Zone 1 | Zone 2 | Zone 3 | Zone 4 | Zone 5 |
| [Ferrocène] (% élevé) [Ar] $[H_2]$ (% élevé) $[H_2O]$ | [Ferrocène] (% faible) [Ar] $[H_2]$ (% faible) [He] | [Ferrocène] (% faible) [Ar] [He] $[NH_3]$ | [Ferrocène] (% faible) [Ar] $[NH_3]$ | [Ferrocène] (% faible) [Ar] $[H_2O]$ |

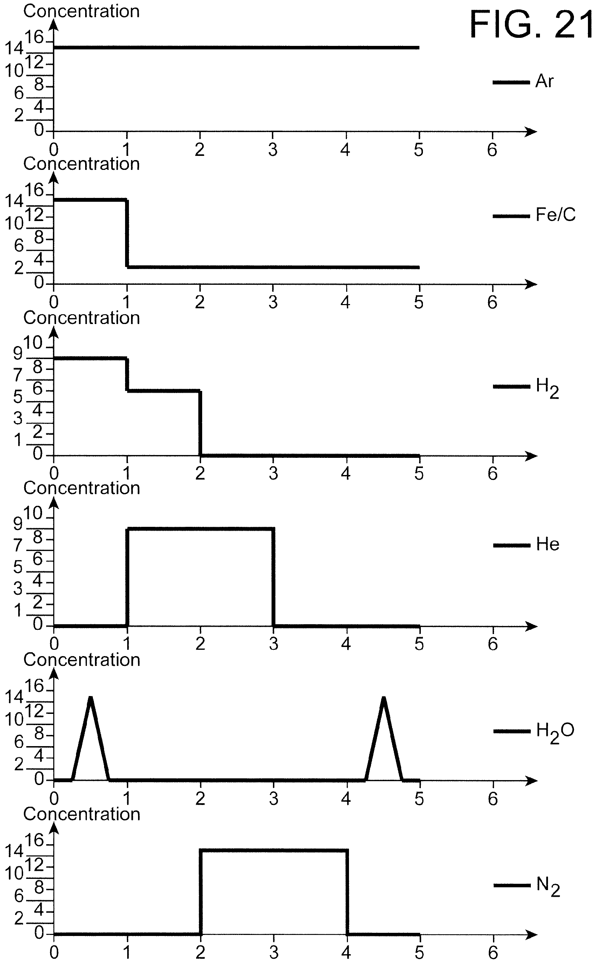

En référence à la figure 21, on peut voir que, tout au long de la première séquence d'injection (qui a lieu dans la zone 1), on injecte une solution de toluène et de ferrocène dont la concentration en ferrocène est élevée dans une atmosphère réactionnelle concentrée en dihydrogène. On injecte également une faible quantité d'eau (l'injection étant pulsée).

Dans la deuxième séquence d'injection, on injecte une solution présentant une faible concentration en ferrocène, de l'argon, une plus faible quantité de dihydrogène par rapport à la première séquence, ainsi que de l'hélium (ou un surplus d'argon).

Dans la troisième séquence d'injection, on injecte une solution présentant la même concentration en ferrocène que dans la deuxième séquence et les mêmes quantités d'argon et d'hélium que dans la deuxième séquence. On injecte en outre une faible quantité d'ammoniac, ce qui a pour effet d'insérer un hétéroatome d'azote comme dopant dans les nanotubes, réalisant ainsi un tapis de nanotubes dopés en leur milieu.

Dans la quatrième séquence d'injection, on injecte une solution ayant la même concentration en ferrocène que dans la troisième séquence dans une atmosphère standard tout argon et on injecte en outre, comme dans la troisième séquence, une faible quantité d'ammoniac.

Enfin, dans la cinquième séquence d'injection, on injecte une solution ayant la même concentration en ferrocène que dans la quatrième séquence dans une atmosphère standard tout argon et on injecte en outre une faible quantité d'eau (l'injection étant pulsée), en stoppant l'injection d'ammoniac pour revenir à des nanotubes non dopés.

**Exemple 5- Mode opératoire pour la réalisation d'un tapis de nanotubes de carbone alignés selon une synthèse séquentielle en mode spatial à cinq séquences d'injection différentes (substrat défilant) en présence d'un fluide réactif carboné.**

Pour cette synthèse, l'enchaînement des séquences présentées dans le tableau 4 permet une variation, dans au moins deux des n zones, d'au moins l'un des paramètres suivants : la composition chimique du gaz porteur, la concentration massique du précurseur catalytique dans le mélange des précurseurs. En plus des espèces injectées dans l'exemple 3, on va en outre injecter un fluide réactif carboné tel que l'acétylène, ce dernier ayant l'avantage de se décomposer dès 600°C, permettant ainsi de travailler à plus basse température.

Les composés et les quantités injectés dans les cinq zones sont résumés dans le tableau 4 ci-dessous.

Tableau 4

| Séquence 1 (0-1) | Séquence 2 (1-5) | | | |
|---|---|---|---|---|
| Zone 1 | Zone 2 | Zone 3 | Zone 4 | Zone 5 |
| [Ferrocène] (% élevé) $[Ar]/[H_2]/[C_2H_2]$ | [Ferrocène] (% faible) $[Ar]/[H_2]/[C_2H_2]$ | [Ferrocène] (% faible) $[Ar]/[H_2]/[C_2H_2]$ | [Ferrocène] (% faible) $[Ar]/[H_2]/[C_2H_2]$ | [Ferrocène] (% faible) $[Ar]/[H_2]/[C_2H_2]$ |

Tout au long de la première séquence d'injection (qui a lieu dans la zone 1), on injecte une solution de toluène et de ferrocène dont la concentration en ferrocène est élevée (par exemple 10 % en poids), en présence d'un mélange de gaz $Ar/H_2/C_2H_2$, avec Ar en tant que gaz porteur et $H_2/C_2H_2$ en tant que fluide réactif. Les proportions du mélange de gaz sont de 3,5/1,5/0,25 $L.min^{-1}$ et le débit du mélange est constant (il est ici d'environ 5 $L.min^{-1}$). Dans la deuxième séquence (qui a lieu dans les zones 2 à 5), on injecte une solution de toluène présentant une faible concentration en ferrocène (par exemple 1,25% en poids), toujours en présence du mélange de gaz $Ar/H_2/C_2H_2$ (proportions et débit inchangés par rapport à la première séquence), ce qui a pour effet de diminuer le diamètre des nanotubes et de permettre leur croissance à plus basse température.

Il est à noter que dans les exemples 2 à 5 ci-dessus, les injections sont continues, à l'exception de l'injection d'eau, dans l'exemple 4, qui est pulsée.

Les différents exemples précédents mettent en évidence la richesse des modes opératoires qu'il est possible de mettre en oeuvre avec le dispositif à n zones selon l'invention pour la réalisation en continu de nanostructures alignés.

Dans les exemples 2 à 5, nous avons choisi de réaliser les opérations d'injection en modifiant, dans au moins deux des n zones, au moins la concentration massique du précurseur catalytique dans le mélange du précurseur catalytique et du précurseur source. Mais il est tout à fait possible de choisir de modifier, à tout le moins, le débit du flux du gaz porteur ou la composition chimique du gaz porteur.

A titre d'exemple, nous avons résumé dans les tableaux 5 et 6 ci-dessous les composés et les quantités injectés dans un dispositif selon l'invention comprenant cinq zones afin de réaliser une synthèse ayant un profil d'injection à deux séquences d'injection, où l'on modifie uniquement le débit du flux du gaz porteur (tableau 5) et où l'on modifie uniquement la composition chimique du gaz porteur (tableau 6).

Dans le tableau 5 ci-après, la concentration en ferrocène est constante et est par exemple inférieure à 0,5 % en poids ; le gaz porteur utilisé est l'argon et son débit est de l'ordre de 5 $L.min^{-1}$ dans la première séquence et de l'ordre de 1 $L.min^{-1}$ dans la deuxième séquence.

Tableau 5

| Séquence 1 (0-1) | Séquence 2 (1-5) | | | |
|---|---|---|---|---|
| Zone 1 | Zone 2 | Zone 3 | Zone 4 | Zone 5 |
| [Ferrocène] (% faible) [Ar] (débit élevé) | [Ferrocène] (% faible) [Ar] (débit faible) | [Ferrocène] (% faible) [Ar] (débit faible) | [Ferrocène] (% faible) [Ar] (débit faible) | [Ferrocène] (% faible) [Ar] (débit faible) |

Dans le tableau 6 ci-dessous, la concentration en ferrocène est constante et est par exemple inférieure à 0,5% ; dans la première séquence, le gaz porteur utilisé est l'hélium, ce qui a pour effet de diminuer le diamètre des nanotubes, tandis que dans la deuxième séquence, la composition chimique du gaz porteur est un mélange d'hélium et d'argon en proportion 70/30 % en volume. Cela a pour effet de jouer aussi sur la température de synthèse des nanotubes, du fait des capacités calorifiques des gaz employés. Dans les deux séquences, le débit du gaz porteur est constant et est par exemple de l'ordre de 5 L.min$^{-1}$.

Tableau 6

| Séquence 1 (0-1) | Séquence 2 (1-5) | | | |
|---|---|---|---|---|
| Zone 1 | Zone 2 | Zone 3 | Zone 4 | Zone 5 |
| [Ferrocène] (% faible) [He] | [Ferrocène] (% faible) [He]/[Ar] | [Ferrocène] (% faible) [He]/[Ar] | [Ferrocène] (% faible) [He]/[Ar] | [Ferrocène] (% faible) [He]/[Ar] |

**REFERENCES CITEES**

**[1]** US 2010/0260933 A1
**[2]** US 2013/0045157 A1
**[3]** US 2009/0053115 A1
**[4]** C. Castro et al., « The rôle of hydrogen in the aerosol-assisted chemical vapor déposition process in producing thin and densely packed vertically aligned carbon nanotubes » CARBON 61 (2013), pages 585-594
**[5]** M. Pinault et al, « Evidence of sequential lift in growth of aligned multiwalled carbon nanotube multilayers », Nano Letters (2005), 5(12), pages 2394-2398
**[6]** FR 2 927 619 A1
**[7]** C. Castro et al., « Dynamics of catalyst particle formation and multi-walled carbon nanotube growth in aerosol-assisted catalytic chemical vapor déposition", CARBON 48 (2010), pages 3807-3816

**Revendications**

**1.** Procédé de fabrication en continu de nanostructures alignées sur un support défilant, les nanostructures étant du type nanofils ou nanotubes, comprenant le convoyage du support à travers un espace chauffé et la synthèse, dans cet espace, des nanostructures alignées sur le support par dépôt chimique catalytique en phase vapeur, le procédé étant **caractérisé en ce que**, l'espace chauffé étant divisé en n zones consécutives dans le sens de convoyage du support, n étant un nombre entier supérieur ou égal à 2, la synthèse des nanostructures résulte d'opérations de chauffage et d'opérations d'injection, dans chacune des n zones, d'un flux d'un aérosol contenant un précurseur catalytique et un précurseur source du matériau des nanostructures à former, véhiculé par un gaz porteur et **en ce que** les opérations d'injection sont réalisées en modifiant, dans au moins deux des n zones, au moins un paramètre choisi parmi le débit du flux du gaz porteur, la composition chimique du gaz porteur, la concentration massique du précurseur catalytique dans le mélange du précurseur catalytique et du précurseur source.

**2.** Procédé de fabrication selon la revendication 1, dans lequel le précurseur catalytique injecté a, dans au moins l'une des n zones, une concentration massique dans le mélange du précurseur catalytique et du précurseur source qui est supérieure ou égale à 0,01 % en poids et inférieure ou égale à 1 % en poids.

**3.** Procédé de fabrication selon la revendication 2, dans lequel le précurseur catalytique injecté dans ladite au moins une des n zones a une concentration massique dans le mélange du précurseur catalytique et du précurseur source qui est supérieure ou égale à 0,05 % en poids et inférieure ou égale à 0,5 % en poids.

**4.** Procédé de fabrication selon l'une quelconque des revendications 1 à 3, dans lequel le précurseur catalytique injecté dans les n zones a une concentration massique dans le mélange du précurseur catalytique et du précurseur source qui est constante.

**5.** Procédé de fabrication selon l'une quelconque des revendications 1 à 3, dans lequel, soit le centre des n zones du dispositif, la concentration totale massique en précurseur catalytique présent dans le mélange du précurseur catalytique et du précurseur source injecté sous forme d'aérosol dans la ou l'ensemble des zones situées en amont du centre selon le sens de convoyage est au moins deux fois supérieure à la concentration totale massique en précurseur catalytique présent dans le mélange du précurseur catalytique et du précurseur source injecté sous forme d'aérosol dans la ou l'ensemble des zones situées en aval du centre selon le sens de convoyage.

**6.** Procédé de fabrication selon l'une quelconque des revendications 1 à 3, dans lequel la concentration massique en précurseur catalytique dans le mélange du précurseur catalytique et du précurseur source injecté sous forme d'aérosol dans l'une des n zones, dite zone de haute concentration, est au moins deux fois supérieure à la concentration massique en précurseur catalytique dans le mélange du précurseur catalytique et du précurseur source injecté sous forme d'aérosol dans chacune des n-1 zones restantes.

**7.** Procédé de fabrication selon la revendication 6, dans lequel la zone de haute concentration est la première zone selon le sens de convoyage.

**8.** Procédé de fabrication selon la revendication 6 ou 7, dans lequel la concentration massique en précurseur catalytique présent dans le mélange du précurseur catalytique et du précurseur source injecté sous forme d'aérosol dans la zone de haute concentration est comprise entre 2 % en poids et la limite de saturation du précurseur catalytique dans le précurseur source et la concentration massique en précurseur catalytique présent dans le mélange du précurseur catalytique et du précurseur source injecté sous forme d'aérosol dans les n-1 zones restantes est inférieure ou égale à 1 % en poids.

**9.** Procédé de fabrication selon la revendication 8, dans lequel la concentration massique en précurseur catalytique présent dans l'aérosol qui est injecté dans la zone de haute concentration est comprise entre 2,5 et 10% en poids et la concentration massique en précurseur catalytique présent dans l'aérosol qui est injecté dans les n-1 autres zones est inférieure ou égale à 0,1 % en poids.

**10.** Procédé de fabrication selon l'une quelconque des revendications 1 à 9, dans lequel les nanostructures sont en carbone, le précurseur catalytique est un métallocène de métaux de transition et le précurseur source est un hydrocarbure.

**11.** Procédé de fabrication selon la revendication 10, dans lequel le précurseur catalytique est le ferrocène et le précurseur source est le toluène.

**12.** Procédé de fabrication selon la revendication 1, dans lequel les opérations d'injection sont en outre réalisées en modifiant, dans au moins deux des n zones, le débit d'injection du mélange du précurseur catalytique et du précurseur source.

**13.** Procédé de fabrication selon la revendication 1 ou la revendication 12, dans lequel les opérations de chauffage sont réalisées à une température différente dans au moins deux des n zones.

**14.** Procédé de fabrication selon la revendication 1 ou la revendication 12, dans lequel la synthèse résulte en outre d'opérations d'injection d'un flux d'au moins un fluide réactif dans au moins une des n zones.

**15.** Procédé de fabrication selon la revendication 14, dans lequel le fluide réactif est choisi parmi l'eau ($H_2O$), l'ammoniac ($NH_3$), l'azote ($N_2$), le dihydrogène ($H_2$), l'acétylène ($C_2H_2$), le méthane ($C_2H_4$), l'éthylène ($CH_3$) et le dioxyde de carbone ($CO_2$).

**16.** Dispositif pour la mise en oeuvre du procédé selon l'une quelconque des revendications 1 à 15, **caractérisé en ce**

**qu'**il comprend :

- une enceinte (1), munie d'une entrée (2) et d'une sortie (3) par lesquelles le support entre et sort respectivement ;
- une chambre de réaction (4), située dans l'enceinte entre l'entrée et la sortie, et divisée en n zones (7), selon le sens de convoyage, n étant un nombre entier supérieur ou égal à 2 ;
- des moyens pour convoyer (5), selon un sens de convoyage, le support de l'entrée (2) à la sortie (3) de l'enceinte en passant par la chambre de réaction (4) ;

et **caractérisé en ce que** chaque zone est équipée :

- d'un premier système d'injection (8) pour injecter, dans la zone associée, un flux d'un aérosol (10a) contenant un précurseur catalytique et un précurseur source du matériau des nanostructures à former, véhiculé par un gaz porteur ;
- d'un premier élément de chauffage individuel (11), configuré pour chauffer le substrat lors de son passage dans la zone associée ;
- d'un deuxième élément de chauffage individuel (9), configuré pour chauffer l'aérosol injecté dans la zone associée.

17. Dispositif selon la revendication 16, dans lequel au moins deux des n premiers systèmes d'injection sont configurés pour injecter l'aérosol avec un paramètre, choisi parmi le débit du gaz porteur et la concentration massique en précurseur catalytique dans le mélange du précurseur catalytique et du précurseur source, qui est différent.

18. Dispositif selon la revendication 16 ou 17, dans lequel au moins une des n zones (7) est en outre équipée d'un deuxième système d'injection pour injecter, dans la zone associée, un flux d'au moins un fluide réactif (10b).

19. Dispositif selon la revendication 18, dans lequel au moins deux des n zones sont équipées du deuxième système d'injection et au moins deux de ces deuxièmes systèmes d'injection sont configurés pour injecter le ou les fluides réactifs, dans les zones associées, avec un paramètre, choisi parmi le débit du ou des fluides réactifs, la composition chimique et la concentration des différents constituants du ou des fluides réactifs, qui est différent.

20. Dispositif selon l'une quelconque des revendications 16 à 19, comprenant en outre des moyens de commande d'injection, associés à chaque premier système d'injection, qui sont conçus pour déclencher une injection d'un flux d'aérosol (10a) dans la zone (7) associée lorsque le support pénètre dans cette zone et maintenir cette injection jusqu'à ce que le support sorte de cette zone.

21. Dispositif selon l'une quelconque des revendications 16 à 20, dans lequel au moins deux zones adjacentes sont séparées l'une de l'autre par une cloison (14) ayant une ouverture permettant le passage du support, des moyens de confinement (6) étant placés au niveau de cette ouverture pour empêcher le passage de fluides et d'aérosols d'une zone à l'autre.

22. Dispositif selon l'une quelconque des revendications 16 à 21, dans lequel l'enceinte comporte en outre une chambre de pré-traitement (15), qui est située en amont de la chambre de réaction, selon le sens de convoyage du support, et qui est munie d'une entrée et d'une sortie (17) par lesquelles le support entre et sort respectivement, la chambre de pré-traitement étant équipée d'un système d'injection d'un fluide et de moyens de chauffage.

23. Dispositif selon l'une quelconque des revendications 16 à 22, dans lequel l'enceinte comporte en outre une chambre de post-traitement (16), qui est située en aval de la chambre de réaction, selon le sens de convoyage du support, et qui est munie d'une entrée (18) et d'une sortie par lesquelles le support entre et sort respectivement, la chambre de post-traitement étant équipée d'un système d'injection d'un fluide et de moyens de chauffage.

**Patentansprüche**

1. Verfahren zur kontinuierlichen Herstellung von auf einem durchlaufenden Träger ausgerichteten Nanostrukturen, wobei die Nanostrukturen in der Art von Nanodrähten oder Nanoröhrchen sind, umfassend das Fördern des Trägers durch einen erwärmten Raum hindurch, und die Synthese, in diesem Raum, der auf dem Träger ausgerichteten Nanostrukturen durch katalytisches chemisches Abscheiden in einer Dampfphase, wobei das Verfahren **dadurch gekennzeichnet ist, dass** die Synthese der Nanostrukturen, da der erwärmte Raum in n aufeinanderfolgende Bereiche in der Förderrichtung des Trägers unterteilt ist, wobei n eine ganze Zahl größer oder gleich 2 ist, aus Heizvorgängen und Injektionsvorgängen, in jedem der n Bereiche, einer Strömung eines Aerosols hervorgeht, das eine katalytisches Vorstufe und eine Quellenvorstufe des zu bildenden Werkstoffes der Nanostrukturen enthält, die durch ein Trägergas transportiert wird, und dadurch, dass die Injektionsvorgänge durch Ändern, in mindestens zwei der n Bereiche, mindestens eines Parameters verwirklicht werden, der aus dem Durchsatz der Strömung des Trägergases, der chemischen Zusammensetzung des Trägergases, der Massenkonzentration der katalytischen Vorstufe in dem Gemisch der katalytischen Vorstufe und der Quellenvorstufe ausgewählt wird.

2. Verfahren zur Herstellung nach Anspruch 1, wobei die in mindestens einem der n Bereiche injizierte katalytische Vorstufe eine Massenkonzentration in dem Gemisch der katalytischen Vorstufe und der Quellenvorstufe aufweist, die größer oder gleich 0,01 Gew.-% und kleiner oder gleich 1 Gew.-% ist.

3. Verfahren zur Herstellung nach Anspruch 2, wobei die in dem mindestens einen der n Bereiche injizierte katalytische Vorstufe eine Massenkonzentration in dem Gemisch der katalytischen Vorstufe und der Quellenvorstufe aufweist, die größer oder gleich 0,05 Gew.-% und kleiner oder gleich 0,5 Gew.-% ist.

4. Verfahren zur Herstellung nach einem der Ansprüche 1 bis 3, wobei die in den n Bereichen injizierte katalytische Vorstufe eine Massenkonzentration in dem Gemisch der katalytischen Vorstufe und der Quellenvorstufe aufweist, die konstant ist.

5. Verfahren zur Herstellung nach einem der Ansprüche 1 bis 3, wobei entweder das Zentrum der n Bereiche der Vorrichtung, die Gesamtmassenkonzentration an katalytischer Vorstufe, die in dem Gemisch der katalytischen Vorstufe und der Quellenvorstufe vorhanden ist, das in Form eines Aerosols in den oder alle Bereiche injiziert wird, die sich stromaufwärts des Zentrums gemäß der Förderrichtung befinden, mindestens doppelt so groß ist, wie die Gesamtmassenkonzentration an katalytischer Vorstufe, die in dem Gemisch der katalytischen Vorstufe und der Quellenvorstufe vorhanden ist, das in Form eines Aerosols in den oder alle Bereiche injiziert wird, die sich stromabwärts des Zentrums gemäß der Förderrichtung befinden.

6. Verfahren zur Herstellung nach einem der Ansprüche 1 bis 3, wobei die Massenkonzentration an katalytischer Vorstufe in dem Gemisch der katalytischen Vorstufe und der Quellenvorstufe, das in Form eines Aerosols in einen der n Bereiche, Hochkonzentrationsbereich genannt, injiziert wird, mindesten doppelt so groß ist, wie die Massenkonzentration an katalytischer Vorstufe in dem Gemisch der katalytischen Vorstufe und der Quellenvorstufe, das in Form eines Aerosols in jeden der n-1 verbleibenden Bereiche injiziert wird.

7. Verfahren zur Herstellung nach Anspruch 6, wobei der Hochkonzentrationsbereich der erste Bereich gemäß der Förderrichtung ist.

8. Verfahren zur Herstellung nach Anspruch 6 oder 7, wobei die Massenkonzentration an katalytischer Vorstufe, die in dem Gemisch der katalytischen Vorstufe und der Quellenvorstufe vorhanden ist, das in Form eines Aerosols in den Hochkonzentrationsbereich injiziert wird, zwischen 2 Gew.-% und der Sättigungsgrenze der katalytischen Vorstufe in der Quellenvorstufe liegt, und die Massenkonzentration an katalytischer Vorstufe, die in dem Gemisch der katalytischen Vorstufe und der Quellenvorstufe vorhanden ist, das in Form eines Aerolsols in die n-1 verbleibenden Bereiche injiziert wird, kleiner oder gleich 1 Gew.-% ist.

9. Verfahren zur Herstellung nach Anspruch 8, wobei die Massenkonzentration an katalytischer Vorstufe, die in dem Aerosol vorhanden ist, das in den Hochkonzentrationsbereich injiziert wird, zwischen 2,5 und 10 Gew.-% liegt, und die Massenkonzentration an katalytischer Vorstufe, die in dem Aerosol vorhanden ist, das in die anderen n-1 Bereiche injiziert wird, kleiner oder gleich 0,1 Gew.-% ist.

10. Verfahren zur Herstellung nach einem der Ansprüche 1 bis 9, wobei die Nanostrukturen aus Kohlenstoff sind, die katalytische Vorstufe ein Metallocen aus Übergangsmetallen ist, und die Quellenvorstufe ein Kohlenwasserstoff ist.

11. Verfahren zur Herstellung nach Anspruch 10, wobei die katalytische Vorstufe Ferrocen ist und die Quellenvorstufe Toluol ist.

12. Verfahren zur Herstellung nach Anspruch 1, wobei Injektionsvorgänge weiter durch Ändern, in mindestens zwei der n Bereiche, des Injektionsdurchsatzes des Gemisches der katalytischen Vorstufe und der Quellenvorstufe verwirklicht werden.

13. Verfahren zur Herstellung nach Anspruch 1 oder Anspruch 12, wobei die Heizvorgänge bei einer Temperatur realisiert werden, die in mindestens zwei der n Bereiche unterschiedlich ist.

14. Verfahren zur Herstellung nach Anspruch 1 oder Anspruch 12, wobei die Synthese weiter aus Injektionsvorgängen einer Strömung mindestens eines reaktionsfähigen Fluids in mindestens einem der n Bereiche hervorgeht.

15. Verfahren zur Herstellung nach Anspruch 14, wobei das reaktionsfähige Fluid aus Wasser ($H_2O$), Ammoniak ($NH_3$), Stickstoff ($N_2$), Diwasserstoff ($H_2$), Azetylen ($C_2H_2$), Methan ($C_2H_4$), Ethylen ($CH_3$) und Kohlendioxid ($CO_2$) ausgewählt wird.

16. Vorrichtung zur Umsetzung des Verfahrens nach einem der Ansprüche 1 bis 15, **dadurch gekennzeichnet, dass** sie umfasst:

- einen Einschluss (1), der mit einem Einlass (2) und einem Auslass (3) versehen ist, durch die der Träger jeweils eintritt und austritt;
- eine Reaktionskammer (4), die sich in dem Einschluss zwischen dem Einlass und dem Auslass befindet, und in n Bereiche (7), gemäß der Förderrichtung, unterteilt ist, wobei n eine ganze Zahl größer oder gleich 2 ist;
- Mittel zum Fördern (5) gemäß einer Förderrichtung, des Trägers vom Einlass (2) zum Auslass (3) des Einschlusses, über die Reaktionskammer (4);

und **dadurch gekennzeichnet, dass** jeder Bereich ausgestattet ist:

- mit einem ersten Injektionssystem (8) zum Injizieren in dem zugeordneten Bereich einer Strömung eines Aerosols (10a), das eine katalytische Vorstufe und eine Quellenvorstufe des Werkstoffes der zu bildenden Nanostrukturen enthält, die von einem Trägergas transportiert wird;
- mit einem ersten einzelnen Heizelement (11), konfiguriert, um das Substrat bei dessen Durchlauf in dem zugeordneten Bereich zu erwärmen;
- mit einem zweiten einzelnen Heizelement (9), konfiguriert, um das in den zugeordneten Bereich injizierte Aerosol zu erwärmen.

17. Vorrichtung nach Anspruch 16, wobei mindestens zwei der ersten n Injektionssysteme konfiguriert sind, um das Aerosol mit einem Parameter zu injizieren, der aus dem Durchsatz des Trägergases und der Massenkonzentration an katalytischer Vorstufe in dem Gemisch der katalytischen Vorstufe und der Quellenvorstufe ausgewählt wird, der unterschiedlich ist.

18. Vorrichtung nach Anspruch 16 oder 17, wobei mindestens einer der n Bereiche (7) weiter mit einem zweiten Injektionssystem zum Injizieren, in dem zugeordneten Bereich, einer Strömung mindestens eines reaktionsfähigen Fluids (10b) ausgerüstet ist.

19. Vorrichtung nach Anspruch 18, wobei mindestens zwei der n Bereiche mit dem zweiten Injektionssystem ausgerüstet sind, und mindestens zwei dieser zweiten Injektionssysteme konfiguriert sind, um das oder die reaktionsfähigen Fluide in den zugeordneten Bereichen mit einem Parameter zu injizieren, der aus dem Durchsatz des oder der reaktionsfähigen Fluide, der chemischen Zusammensetzung und der Konzentration der verschiedenen Bestandteile des oder der reaktionsfähigen Fluide ausgewählt wird, der unterschiedlich ist.

20. Vorrichtung nach einem der Ansprüche 16 bis 19, weiter Injektionssteuerungsmittel umfassend, die jedem ersten Injektionssystem zugeordnet sind, die gestaltet sind, um eine Injektion einer Aerosol-Strömung (10a) in dem zugeordneten Bereich (7) auszulösen, wenn der Träger in diesen Bereich eindringt, und diese Injektion beizubehalten, bis der Träger aus diesem Bereich austritt.

21. Vorrichtung nach einem der Ansprüche 16 bis 20, wobei mindestens zwei benachbarte Bereiche durch eine Wand (14) voneinander getrennt sind, die eine Öffnung aufweist, die den Durchlass des Trägers erlaubt, wobei Einschlussmittel (6) im Bereich dieser Öffnung platziert sind, um den Durchlass von Fluiden und von Aerosolen von einem Bereich zum anderen zu verhindern.

22. Vorrichtung nach einem der Ansprüche 16 bis 21, wobei der Einschluss weiter eine Vorbehandlungskammer (15) beinhaltet, die sich stromaufwärts der Reaktionskammer gemäß der Förderrichtung des Trägers befindet, und die mit einem Einlass und einem Auslass (17) versehen ist, durch die der Träger jeweils eintritt und austritt, wobei die Vorbehandlungskammer mit einem Injektionssystem eines Fluids und Heizmitteln ausgerüstet ist.

23. Vorrichtung nach einem der Ansprüche 16 bis 22, wobei der Einschluss weiter eine Nachbehandlungskammer (16) beinhaltet, die sich stromabwärts der Reaktionskammer gemäß der Förderrichtung des Trägers befindet, und die mit einem Einlass (18) und einem Auslass versehen ist, durch die der Träger jeweils eintritt und austritt, wobei die Nachbehandlungskammer mit einem Injektionssystem eines Fluids und Heizmitteln ausgerüstet ist.

**Claims**

1.  A method for continuously manufacturing nanostructures aligned on a travelling support, the nanostructures being of the nanowire or nanotube type, comprising conveying the support through a heated space and synthesising, in this space, the nanostructures aligned on the support by catalytic chemical vapour deposition,
    the method being **characterised in that**, the heated space being divided into n consecutive zones in the conveying direction of the support, n being an integer greater than or equal to 2, the synthesis of the nanostructures results from operations of heating and operations of injecting, into each of the n zones, a stream of an aerosol containing a catalytic precursor and a source precursor of the material of the nanostructures to be formed, carried by a carrier gas and **in that** the injection operations are carried out by modifying, in at least two of the n zones, at least one parameter selected from the flow rate of the carrier gas stream, the chemical composition of the carrier gas, the mass concentration of the catalytic precursor in the mixture of the catalytic precursor and the source precursor.

2.  The manufacturing method according to claim 1, wherein the catalytic precursor injected has, in at least one of the n zones, a mass concentration in the mixture of the catalytic precursor and the source precursor which is greater than or equal to 0.01 weight % and less than or equal to 1 weight %.

3.  The manufacturing method according to claim 2, wherein the catalytic precursor injected into said at least one of the n zones has a mass concentration in the mixture of the catalytic precursor and the source precursor which is greater than or equal to 0.05 weight % and less than or equal to 0.5 weight %.

4.  The manufacturing method according to any of claims 1 to 3, wherein the catalytic precursor injected into the n zones has a mass concentration in the mixture of the catalytic precursor and the source precursor which is constant.

5.  The manufacturing method according to any of claims 1 to 3, wherein, given the centre of the n zones of the device, the total mass concentration of catalytic precursor present in the mixture of the catalytic precursor and the source precursor injected as an aerosol into the zone or all the zones located upstream of the centre along the conveying direction is at least twice greater than the total mass concentration of catalytic precursor present in the mixture of the catalytic precursor and the source precursor injected as an aerosol into the zone or all the zones located downstream of the centre along the conveying direction.

6.  The manufacturing method according to any of claims 1 to 3, wherein the mass concentration of catalytic precursor in the mixture of the catalytic precursor and the source precursor injected as an aerosol into one of the n zones, referred to as the high concentration zone, is at least twice greater than the mass concentration of catalytic precursor in the mixture of the catalytic precursor and the source precursor injected as an aerosol into each of the n-1 remaining zones.

7.  The manufacturing method according to claim 6, wherein the high concentration zone is the first zone along the conveying direction.

8.  The manufacturing method according to claim 6 or 7, wherein the mass concentration of catalytic precursor present in the mixture of the catalytic precursor and the source precursor injected as an aerosol into the high concentration zone is between 2 weight % and the saturation limit of the catalytic precursor in the source precursor and the mass concentration of catalytic precursor present in the mixture of the catalytic precursor and the source precursor injected as an aerosol into the n-1 remaining zones is less than or equal to 1 weight %.

9.  The manufacturing method according to claim 8, wherein the mass concentration of catalytic precursor present in the aerosol which is injected into the high concentration zone is between 2.5 and 10 weight % and the mass concentration of catalytic precursor present in the aerosol which is injected into the n-1 other zones is less than or equal to 0.1 weight %.

10. The manufacturing method according to any of claims 1 to 9, wherein the nanostructures are of carbon, the catalytic precursor is a metallocene of transition metals and the source precursor is a hydrocarbon.

11. The manufacturing method according to claim 10, wherein the catalytic precursor is ferrocene and the source precursor is toluene.

12. The manufacturing method according to claim 1, wherein the injection operations are further carried out by modifying, in at least two of the n zones, the injection flow rate of the mixture of the catalytic precursor and the source precursor.

13. The manufacturing method according to claim 1 or claim 12, wherein the heating operations are carried out at a different temperature in at least two of the n zones.

14. The manufacturing method according to claim 1 or claim 12, wherein the synthesis further results from operations of injecting a stream of at least one reactive fluid into at least one of the n zones.

15. The manufacturing method according to claim 14, wherein the reactive fluid is selected from water ($H_2O$), ammonia ($NH_3$), nitrogen ($N_2$), dihydrogen ($H_2$), acetylene ($C_2H_2$), methane ($C_2H_4$), ethylene ($CH_3$) and carbon dioxide ($CO_2$).

16. A device for implementing the method according to any of claims 1 to 15, **characterised in that** it comprises:

   - an enclosure (1), provided with an inlet (2) and an outlet (3) through which the support respectively enters and exits;
   - a reaction chamber (4), located in the enclosure between the inlet and the outlet, and divided into n zones (7), along the conveying direction, n being an integer greater than or equal to 2;
   - means for conveying (5), along a conveying direction, the support from the inlet (2) to the outlet (3) of the enclosure by passing through the reaction chamber (4);

   and **characterised in that** each zone is equipped with:

   - a first injection system (8) to inject, into the associated zone, a stream of an aerosol (10a) containing a catalytic precursor and a source precursor of the material of the nanostructures to be formed, carried by a carrier gas;
   - a first individual heating element (11), configured to heat the substrate as it passes into the associated zone;
   - a second individual heating element (9) configured to heat the aerosol injected into the associated zone.

17. The device according to claim 16, wherein at least two of the n first injection systems are configured to inject the aerosol with a parameter, selected from the flow rate of the carrier gas and the mass concentration of catalytic precursor in the mixture of the catalytic precursor and the source precursor, which is different.

18. The device according to claim 16 or 17, wherein at least one of the n zones (7) is further equipped with a second injection system to inject, into the associated zone, a stream of at least one reactive fluid (10b).

19. The device according to claim 16, wherein at least two of the n zones are equipped with the second injection system and at least two of these second injection systems are configured to inject the reactive fluid(s), into the associated zones, with a parameter, selected from the flow rate of the reactive fluid(s), the chemical composition and the concentration of different constituents of the reactive fluid(s), which is different.

20. The device according to any of claims 16 to 19, further comprising injection control means, associated with each first injection system, which are designed to trigger injection of a stream of aerosol (10a) into the associated zone (7) when the support penetrates this zone and maintain this injection until the support exits this zone.

21. The device according to any of claims 16 to 20, wherein at least two adjacent zones are separated from each other by a partition wall (14) having an opening enabling the support to pass therethrough, confinement means (6) being placed at this opening to prevent fluids and aerosols from passing from one zone to the other.

22. The device according to any of claims 16 to 21, wherein the enclosure further includes a pre-treatment chamber (15), which is located upstream of the reaction chamber, along the conveying direction of the support, and which is provided with an inlet and an outlet (17) through which a support respectively enters and exits, the pre-treatment chamber being equipped with a system for injecting a fluid and heating means.

23. The device according to any of claims 16 to 22, wherein the enclosure further includes a post-treatment chamber (16), which is located downstream of the reaction chamber, along the conveying direction of the support, and which is provided with an inlet (18) and an outlet through which the support respectively enters and exits, the post-treatment chamber being equipped with a system for injecting a fluid and heating means.

FIG. 1

FIG. 2

FIG. 3

FIG. 4a

FIG. 4b

FIG. 4c

FIG. 5a        FIG. 5b

FIG. 6

EP 3 068 725 B1

FIG. 7

FIG. 8

30

FIG. 9a

FIG. 9b

FIG. 10a

FIG. 10b

FIG. 11a

FIG. 11b

FIG. 12a

FIG. 12b

FIG. 12c

FIG. 13

FIG. 14a

FIG. 14b

Déplacement Raman (cm$^{-1}$)

FIG. 15

FIG. 16

FIG. 17

FIG. 18a

FIG. 18b

FIG. 19

FIG. 20

FIG. 21

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 20100260933 A1
- US 20130045157 A1
- US 20090053115 A1
- FR 2927619 A1

### Littérature non-brevet citée dans la description

- **C. CASTRO et al.** The rôle of hydrogen in the aerosol-assisted chemical vapor déposition process in producing thin and densely packed vertically aligned carbon nanotubes. *CARBON,* 2013, vol. 61, 585-594
- **M. PINAULT et al.** Evidence of sequential lift in growth of aligned multiwalled carbon nanotube multilayers. *Nano Letters,* 2005, vol. 5 (12), 2394-2398
- **C. CASTRO et al.** Dynamics of catalyst particle formation and multi-walled carbon nanotube growth in aerosol-assisted catalytic chemical vapor déposition. *CARBON,* 2010, vol. 48, 3807-3816